# EUROPEAN PATENT SPECIFICATION

(11) **EP 3 355 354 B1**
(45) Date of publication and mention of the grant of the patent: **23.02.2022**
(21) Application number: 17785850.3
(22) Date of filing: 11.04.2017
(51) Int. Cl.: H01L 27/11573, H01L 21/336, H01L 21/822, H01L 27/04, H01L 29/788, H01L 29/792, G11C 5/14, G11C 16/06, H01L 21/28, H01L 29/423, H01L 29/66, H01L 27/06, H01L 27/1157, H01L 49/02, H02M 3/07

(54) **NONVOLATILE SEMICONDUCTOR STORAGE DEVICE**
NICHTFLÜCHTIGE HALBLEITERSPEICHERVORRICHTUNG
MÉMOIRE À SEMI-CONDUCTEUR NON VOLATILE

(30) Priority: 20.04.2016 JP 2016084337
(43) Date of publication of application: 01.08.2018
(73) Proprietor: Floadia Corporation, Kodaira-shi, Tokyo 187-0031 (JP)
(72) Inventor: NODA Satoshi, Kodaira-shi, Tokyo 187-0031 (JP); TANIGUCHI Yasuhiro, Kodaira-shi, Tokyo 187-0031 (JP); KASAI Hideo, Kodaira-shi, Tokyo 187-0031 (JP); KATO Takafumi, Kodaira-shi, Tokyo 187-0031 (JP); KAWASHIMA Yasuhiko, Kodaira-shi, Tokyo 187-0031 (JP); OWADA Fukuo, Kodaira-shi, Tokyo 187-0031 (JP)
(74) Representative: Bandpay & Greuter
(86) International application number: PCT/JP2017/014766
(87) International publication number: WO 2017/183511

(56) References cited:
- JP-A- 2010 259 155
- JP-A- 2010 259 155
- JP-A- 2010 278 314
- JP-A- 2012 248 652
- JP-A- 2014 017 343
- JP-A- 2014 078 661
- JP-A- 2014 229 844
- US-A1- 2011 233 649
- US-A1- 2011 260 228

## Description

### Technical Field

The present invention relates to a non-volatile semiconductor memory device.

### Background Art

A conventionally known non-volatile semiconductor memory device includes memory cells arranged in a matrix of rows and columns and each including a charge storage layer in a memory gate structure. In such a non-volatile semiconductor memory device, data is programmed by injecting charge into the charge storage layer of each memory cell, or data is erased by removing charge from the charge storage layer.

The charge injection into the charge storage layer of the memory cell is achieved by applying a low bit voltage to a channel layer of the memory gate structure and applying a high charge storage gate voltage to a memory gate electrode to cause a quantum tunneling effect due to a voltage difference between the bit voltage and the memory gate voltage.

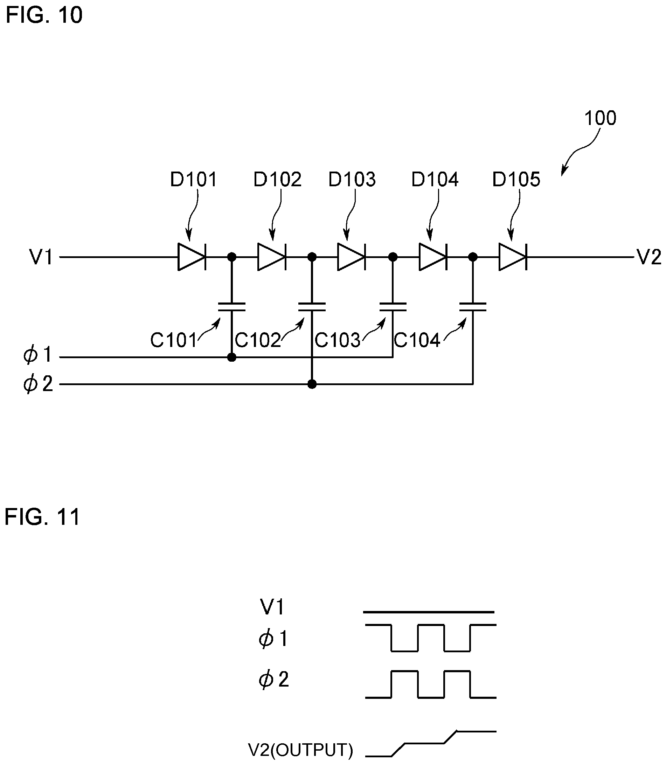

A known configuration of such a non-volatile semiconductor memory device includes a charge pump circuit configured to generate the high charge storage gate voltage to be applied to the memory cell. A known basic charge pump circuit is a Dixon charge pump circuit. FIG. 10 is a circuit diagram of a Dixon charge pump circuit 100 including, for example, four stages.

The Dixon charge pump circuit 100 has a configuration in which a plurality of PN junction diodes D101, D102, D103, D104, and D105 are connected in series between an input electrode and an output electrode. One end of each of capacitive elements C101, C102, C103, and C104 is connected with the corresponding one of cathodes of the PN junction diodes D101, D102, D103, and D104. Voltage of a first clock φ1 is applied to the other end of each of the capacitive elements C101 and C103 at odd-numbered stages. Voltage of a second clock φ2 having a phase opposite to that of the first clock φ1 is applied to the other end of each of the capacitive elements C102 and C104 at even-numbered stages. As illustrated in FIG. 11, voltages at high and low levels of the first clock φ1 and the second clock φ2 having phases opposite to each other are alternately applied to the capacitive elements C101 and C103 and the capacitive elements C102 and C104, respectively. In FIG. 11, V1 denotes a constant input voltage input from the input electrode, and V2 denotes an output voltage output from the output electrode.

In the charge pump circuit 100, the capacitive elements C101, C102, C103, and C104 repeat charging and discharging at the timings of voltage change between high and low levels of the first clock φ1 and the second clock φ2. The charge pump circuit 100 outputs, as the output voltage V2 from the output electrode, a voltage obtained by multiplying a voltage having the amplitude of the first clock φ1 or the second clock φ2 by the number of stages of the capacitive elements C101, C102, C103, and C104. In this manner, the charge pump circuit 100 generates the increased output voltage V2.

In the charge pump circuit 100 thus configured, the capacitive elements C101, C102, C103, and C104 each need to have an excellent breakdown voltage characteristic and a stable capacitor characteristic. For example, Patent Literature 1 discloses a manufacturing method of forming a capacitive element simultaneously with a memory cell through a process of manufacturing the memory cell. Specifically, Patent Literature 1 discloses a technology of forming, through a process of manufacturing a charge-storage-type memory cell including a control gate electrode and a memory gate electrode, a capacitive element used for a drive circuit of the memory cell.

In the technology disclosed in Patent Literature 1, after the control gate electrode is formed, an ONO film as a stack of an oxide silicon film, a silicon nitride film to be a charge storage layer, and another oxide silicon film is formed in a memory cell formation region and a capacitive element formation region, and then the memory gate electrode is formed at a certain position on the ONO film in the memory cell formation region. In the technology disclosed in Japanese Patent Laid-Open No. 2014-229844 , part of the ONO film for achieving charge storage at the memory cell is allowed to remain in the capacitive element formation region and used as a capacitive insulating film of the capacitive element.

Document KIKUCHI TAKESHI. "Semiconductor device and manufacturing method of the same", Patent JP2014078661A, discloses a memory cell comprising memory gate electrodes MG formed on both sides of a control gate electrode CG with an ONO film therebetween, and a capacitor element comprising polysilicon films P1 being same layers with a control gate electrode CG and polysilicon films P2 being same layers with memory gate electrodes MG arranged with the ONO film therebetween. Note that the capacitor element is formed not on an isolation film but on a semiconductor substrate. Similarly, document KAWASHIMA YOSHIYUKI, "SEMICONDUCTOR

DEVICE"; Patent US2011260228A1; discloses a memory cell comprising a spacer-shaped memory gate formed on both sides of the control gate.

### Summary of Invention

### Technical Problem

However, the ONO film to be used as a capacitive insulating film has a film quality and a thickness that are optimized mainly for programming operation, reading operation, and erasing operation of the memory cell, and thus has an insufficient breakdown voltage characteristic when used as a capacitive insulating film and receiving continuous application of a high voltage. In particular, in the Dixon charge pump circuit illustrated in FIG. 11, the high charge storage gate voltage is generated at, for example, a capacitive element at the last stage, and thus continuously applied to the capacitive insulating film of the capacitive element. Thus, when the ONO film is used as a capacitive insulating film in the conventional charge pump circuit 100, the breakdown voltage of the capacitive insulating film is insufficient.

Moreover, when the ONO film is used as a capacitive insulating film, the high voltage application causes carrier injection from a capacitor electrode into the silicon nitride film inside the capacitive insulating film, which leads to an unstable capacitor characteristic.

To avoid the above-described problem, for example, a plurality of capacitive elements provided in a charge pump circuit are divided into a pre-stage side and a post-stage side, and separate power supplies are provided to a plurality of capacitive elements on the pre-stage side and a plurality of capacitive elements on the post-stage side. However, the configuration of a non-volatile semiconductor memory device including such a charge pump circuit is complicated and cannot be downsized due to a plurality of power supplies provided to apply different voltages to the plurality of capacitive elements on the pre-stage side and the plurality of capacitive elements on the post-stage side, respectively.

The present invention is intended to solve the above-described problem by providing a non-volatile semiconductor memory device that includes a capacitive element having an improved breakdown voltage characteristic and a stabilized capacitor characteristic, and achieves downsizing.

### Solution to Problem

To solve the above-described problem, a non-volatile semiconductor memory device according to the present invention includes a memory cell provided on a semiconductor substrate, and a charge pump circuit disposed on an insulating layer provided on the semiconductor substrate, according to claim 1.

The memory cell includes: a memory gate structure in which a lower memory gate insulating film, a charge storage layer, an upper memory gate insulating film, and a memory gate electrode are stacked; a first sidewall spacer made of an insulating material and provided along one side surface of the memory gate structure; a second sidewall spacer made of the insulating material and provided along the other side surface of the memory gate structure; a first select gate structure that is disposed along the first sidewall spacer and in which a first select gate electrode is provided on a first select gate insulating film; a second select gate structure that is disposed along the second sidewall spacer and in which a second select gate electrode is provided on a second select gate insulating film; a drain region provided on a surface of the semiconductor substrate, which is adjacent to the first select gate structure, insulated from the first select gate electrode, and electrically connected with a bit line; and a source region provided on a surface of the semiconductor substrate, which is adjacent to the second select gate structure, insulated from the second select gate electrode, and electrically connected with a source line. The charge pump circuit includes a plurality of capacitive elements. Each capacitive element includes, between a capacitor electrode and a capacitor sidewall electrode, a capacitive sidewall insulating film made of a layer same as a layer of the first sidewall spacer and the second sidewall spacer.

### Advantageous Effects of Invention

In the present invention, a film of which a sidewall spacer of a memory cell is made is used as a capacitive sidewall insulating film of a capacitive element in a charge pump circuit provided on a semiconductor substrate on which the memory cell is provided. The film quality and thickness of the sidewall spacer of the memory cell can be adjusted mainly for breakdown voltage. Thus, an improved breakdown voltage characteristic and a stabilized capacitor characteristic can be obtained for the capacitive element when the sidewall spacer is used as the capacitive sidewall insulating film of the capacitive element of the charge pump circuit. The above-described configuration does not need a power supply for achieving low voltage application to the capacitive element, thereby achieving a simplified and downsized configuration accordingly.

### Brief Description of Drawings

FIG. 1 is a cross-sectional view illustrating the configuration of a non-volatile semiconductor memory device according to the present invention.
FIG. 2 is a circuit diagram illustrating a circuit configuration of a charge pump circuit including two capacitive elements.
FIG. 3 is a schematic view illustrating a planar layout of the charge pump circuit including two capacitive elements.
FIG. 4 is a schematic view illustrating a sectional configuration taken along line B-B' in FIG. 3.
FIG. 5 is a schematic view illustrating a planar layout of a charge pump circuit including four capacitive elements.
FIG. 6 is a cross-sectional view illustrating the configuration of a non-volatile semiconductor memory device according to another embodiment.
FIG. 7 is a schematic view illustrating a planar layout of a non-volatile semiconductor memory device including a fin.
FIG. 8A is a schematic view illustrating a sectional configuration taken along line D-D' in FIG. 7; FIG. 8B is a schematic view illustrating a sectional configuration taken along line E-E' in FIG. 7.
FIG. 9 is a schematic view illustrating a sectional configuration taken along line F-F' in FIG. 7.
FIG. 10 is a circuit diagram illustrating a circuit configuration of a conventional charge pump circuit.
FIG. 11 is a timing chart illustrating a relation among an input voltage V1 applied to a charge pump circuit, voltages of a first clock φ1 and a second clock φ2, and an output voltage V2.

### Description of Embodiments

Hereinafter, embodiments of the present invention will be described in the following order.
1. Configuration of non-volatile semiconductor memory device according to the present invention
   1-1. Memory cell
      1-1-1. Operation of selected program memory cell
      1-1-2. Operation of nonselected program memory cell
      1-1-3. Operation of read memory cell
      1-1-4. Operation of erase memory cell
   1-2. Charge pump circuit
2. Operations and effects
3. Charge pump circuit including four capacitive elements
4. Non-volatile semiconductor memory device according to another embodiment
5. Non-volatile semiconductor memory device including fin
6. Others

### (1) Configuration of non-volatile semiconductor memory device according to the present invention

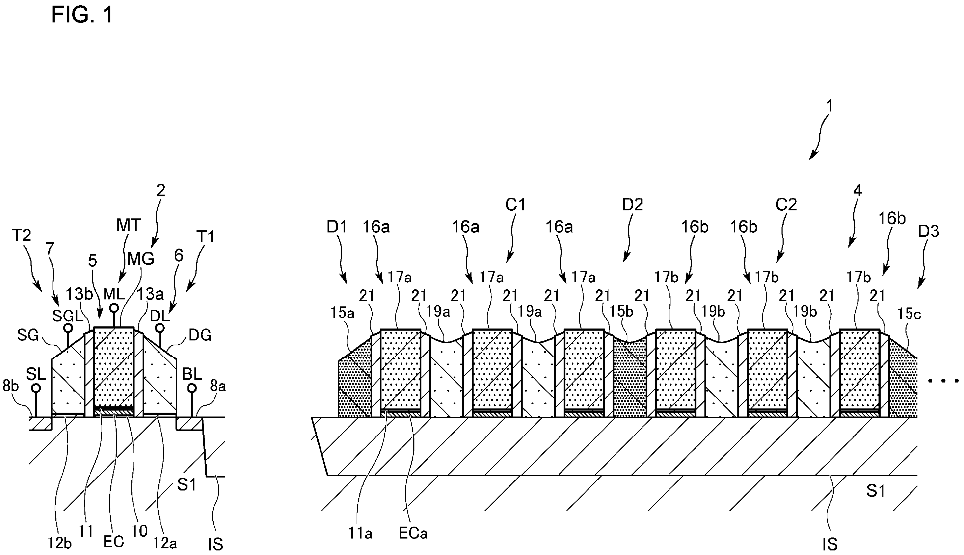

As illustrated in FIG. 1, in a non-volatile semiconductor memory device 1, a memory cell 2 and a charge pump circuit 4 are disposed on an identical semiconductor substrate S1. For example, a voltage obtained by increasing an input voltage at the charge pump circuit 4 is applied to a memory gate electrode MG of the memory cell 2. Although FIG. 1 illustrates only one memory cell 2, but a plurality of memory cells 2 are disposed in row and column directions in reality, and a memory cell array is composed of the memory cells 2 disposed in a matrix of rows and columns.

### (1-1) Memory cell

The memory cell 2 includes, for example, on the P-type semiconductor substrate S1, a memory gate structure 5 included in an N-type memory transistor MT, a first select gate structure 6 included in a first select transistor T1 made of an N-type metal-oxide-semiconductor (MOS), and a second select gate structure 7 included in a second select transistor T2 made of an N-type MOS.

A drain region 8a and a source region 8b are disposed on a surface of the semiconductor substrate S1 with a certain distance provided therebetween. The first select gate structure 6, the memory gate structure 5, and the second select gate structure 7 are disposed between the drain region 8a and the source region 8b. The drain region 8a is disposed on part of the surface of the semiconductor substrate S1, which is adjacent to the first select gate structure 6. The drain region 8a is connected with a bit line BL so that a bit voltage applied to the bit line BL is applied to the drain region 8a. The source region 8b is disposed on part of the surface of the semiconductor substrate S1, which is adjacent to the second select gate structure 7. The source region 8b is connected with a source line SL so that a source voltage applied to the source line SL is applied to the source region 8b.

The memory gate structure 5 includes, through a lower memory gate insulating film 10 made of an insulating material such as oxide silicon (SiO or SiO₂), a charge storage layer EC made of, for example, silicon nitride (Si₃N₄), silicon oxynitride (SiON), alumina (Al₂O₃), or hafnium oxide (HfO₂) on the semiconductor substrate S1 between the drain region 8a and the source region 8b. The memory gate structure 5 further includes, on the charge storage layer EC, the memory gate electrode MG through an upper memory gate insulating film 11 made of an insulating material same as that of the lower memory gate insulating film 10. In the memory gate structure 5 thus configured, the charge storage layer EC is insulated from the semiconductor substrate S1 and the memory gate electrode MG by the lower memory gate insulating film 10 and the upper memory gate insulating film 11.

The memory gate electrode MG is made of a conductive material such as polysilicon, and receives application of a charge storage gate voltage increased at, for example, the charge pump circuit 4 to be described later through a memory gate line ML. A wall-shaped sidewall spacer 13a made of an insulating material such as oxide silicon (SiO or SiO₂) is disposed along a first sidewall of the memory gate structure 5, and thus the memory gate structure 5 is adjacent to the first select gate structure 6 through the sidewall spacer 13a. The sidewall spacer 13a disposed between the memory gate structure 5 and the first select gate structure 6 has a thickness large enough to insulate the memory gate electrode MG of the memory gate structure 5 from a first select gate electrode DG of the first select gate structure 6.

When the distance between the memory gate electrode MG and the first select gate electrode DG is less than 5 nm, voltage application to the memory gate electrode MG and the first select gate electrode DG potentially causes breakdown voltage failure to the sidewall spacer 13a. When the distance between the memory gate electrode MG and the first select gate electrode DG exceeds 40 nm, the resistance of the semiconductor substrate S1 (for example, a region (surface region) up to a depth of 50 nm from the surface) increases between the memory gate electrode MG and the first select gate electrode DG and hinders flow of readout current between the memory gate structure 5 and the first select gate structure 6 at data reading.

Thus, in the present embodiment, the distance between the memory gate electrode MG and the first select gate electrode DG is preferably 5 nm to 40 nm inclusive, and the thickness of the sidewall spacer 13a is preferably 5 nm to 40 nm inclusive.

In the first select gate structure 6, a first select gate insulating film 12a made of an insulating material such as oxide silicon (SiO or SiO₂) and having a thickness of 9 nm or smaller, preferably 3 nm or smaller, is provided on the semiconductor substrate S1 between the sidewall spacer 13a and the drain region 8a. In this case, the first select gate insulating film 12a is formed through a manufacturing process different from that for the sidewall spacer 13a and a sidewall spacer 13b, and has a thickness smaller than the thicknesses of the sidewall spacers 13a and 13b.

Additionally, in the first select gate structure 6, the first select gate electrode DG made of a conductive material such as polysilicon is disposed on the first select gate insulating film 12a to receive predetermined voltage application from a first select gate line DL.

The wall-shaped sidewall spacer 13b made of an insulating material such as oxide silicon (SiO or SiO₂) is disposed on a second sidewall of the memory gate structure 5, and thus the memory gate structure 5 is adjacent to the second select gate structure 7 through the sidewall spacer 13b. The second sidewall spacer 13b disposed between the memory gate structure 5 and the second select gate structure 7 has a thickness large enough to insulate the memory gate electrode MG of the memory gate structure 5 from a second select gate electrode SG of the second select gate structure 7.

Similarly to the distance between the memory gate electrode MG and the first select gate electrode DG described above, the distance between the memory gate electrode MG and the second select gate electrode SG is preferably 5 nm to 40 nm inclusive to avoid any occurrence of breakdown voltage failure to the sidewall spacer 13b and decrease of readout current between the memory gate structure 5 and the second select gate structure 7. Thus, in the present embodiment, the thickness of the sidewall spacer 13b provided between the memory gate electrode MG and the second select gate electrode SG is preferably 5 nm to 40 nm inclusive.

In the second select gate structure 7, a second select gate insulating film 12b made of an insulating material such as oxide silicon (SiO or SiO₂) and having a thickness of 9 nm or smaller, preferably 3 nm or smaller, is provided on the semiconductor substrate S1 between the sidewall spacer 13b and the source region 8b. In this case, the second select gate insulating film 12b is formed through a manufacturing process different from that for the sidewall spacers 13a and 13b, and has a thickness smaller than the thicknesses of the sidewall spacers 13a and 13b.

Additionally, in the second select gate structure 7, the second select gate electrode SG made of a conductive material such as polysilicon is disposed on the second select gate insulating film 12b to receive predetermined voltage application from a second gate line SGL.

The sidewall spacers 13a and 13b provided in the memory cell 2 are formed by chemical vapor deposition (CVD) have excellent film qualities and high breakdown voltages as compared to an oxide film formed by thermally oxidizing polysilicon, and can be highly freely designed to have thicknesses without restriction due to consumption of polysilicon through thermal oxidation.

The thicknesses and film qualities of the lower memory gate insulating film 10, the charge storage layer EC, the upper memory gate insulating film 11, the first select gate insulating film 12a, and the second select gate insulating film 12b are restricted to achieve optimization of programming operation, reading operation, and erasing operation of the memory cell 2. However, the sidewall spacers 13a and 13b are formed as layers independent and different from the lower memory gate insulating film 10 and the like described above, and thus free from the above-described restriction. Accordingly, the thicknesses and film qualities of the sidewall spacers 13a and 13b can be set mainly for breakdown voltage between the memory gate structure 5 and the first select gate structure 6 and breakdown voltage between the memory gate structure 5 and the second select gate structure 7.

### (1-1-1) Operation of selected program memory cell

The following describes operation of the memory cell (selected program memory cell) 2, into the charge storage layer EC of which charge is injected. A charge storage gate voltage Vprog (for example, a voltage of 12 V) is applied from the memory gate line ML to the memory gate electrode MG, and a reference voltage Vss (for example, a voltage of 0 V) is applied as a substrate voltage to the semiconductor substrate S1. The reference voltage Vss (for example, a voltage of 0 V) is applied as a gate off voltage to the second select gate electrode SG from the second select gate line SGL, and the reference voltage Vss (for example, a voltage of 0 V) is applied as a source off voltage to the source region 8b from the source line SL.

Accordingly, the second select transistor T2 is turned off so that a source side non-conductive region is formed on the semiconductor substrate S1 directly below the second select gate structure 7. The source side non-conductive region blocks electrical connection between the source region 8b and a channel layer formation carrier region (region in which carriers are induced to form a channel layer) of the semiconductor substrate S1 directly below the memory gate structure 5, thereby preventing voltage application from the source line SL to the channel layer formation carrier region.

A power supply voltage Vdd (for example, a voltage larger than 0 V and equal to or smaller than 1.5 V) is applied as a first select gate line select voltage to the first select gate electrode DG from the first select gate line DL, and the reference voltage Vss (for example, a voltage of 0 V) is applied as a program voltage to the drain region 8a from the bit line BL. Accordingly, the first select transistor T1 is turned on so that a drain side conduction region is formed on the semiconductor substrate S1 directly below the first select gate structure 6, thereby electrically connecting the drain region 8a with the channel layer formation carrier region directly below the memory gate structure 5.

As a result, carriers are induced in the channel layer formation carrier region to form a channel layer at a potential same as the program voltage (reference voltage Vss (for example, a voltage of 0 V)) on the surface of the semiconductor substrate S1. Accordingly, in the selected program memory cell 2, a large voltage difference of, for example, 12 V is generated between the memory gate electrode MG and the channel layer in the memory gate structure 5 to cause charge injection into the charge storage layer EC by the quantum tunneling effect, thereby achieving a data programmed state.

### (1-1-2) Operation of nonselected program memory cell

The following describes operation of the memory cell (nonselected program memory cell) 2 that shares the first select gate line DL with a selected program memory cell, and charge injection to the charge storage layer EC of which is prevented. Similarly to the case of a selected program memory cell, the charge storage gate voltage Vprog is applied from the memory gate line ML to the memory gate electrode MG of the nonselected program memory cell 2, and the reference voltage Vss is applied as a substrate voltage to the semiconductor substrate S1.

Similarly to the case of a selected program memory cell, the reference voltage Vss (for example, a voltage of 0 V) is applied as a gate off voltage to the second select gate electrode SG from the second select gate line SGL, and the reference voltage Vss is applied as a source off voltage to the source region 8b from the source line SL. Accordingly, the second select transistor T2 is turned off so that a source side non-conductive region is formed on the semiconductor substrate S1 directly below the second select gate structure 7. The source side non-conductive region blocks electrical connection between the source region 8b and the channel layer formation carrier region of the semiconductor substrate S1 directly below the memory gate structure 5, thereby preventing voltage application from the source line SL to the channel layer formation carrier region.

The power supply voltage Vdd (for example, a voltage larger than 0 V and equal to or smaller than 1.5 V) is applied as a first select gate line select voltage to the first select gate electrode DG from the first select gate line DL, and the power supply voltage Vdd is applied as a program prevention voltage to the drain region 8a from the bit line BL. Accordingly, the first select transistor T1 is turned off so that a drain side non-conductive region is formed on the semiconductor substrate S1 directly below the first select gate structure 6. The drain side non-conductive region blocks electrical connection between the drain region 8a and the channel layer formation carrier region directly below the memory gate structure 5, thereby preventing voltage application from the bit line BL to the channel layer formation carrier region.

As a result, in the nonselected program memory cell 2, a depleted layer is formed in the channel layer formation carrier region directly below the memory gate structure 5. Accordingly, the potential of the semiconductor substrate S1 directly below the memory gate structure 5 increases based on the charge storage gate voltage, so that the voltage difference between the memory gate electrode MG and the surface of the semiconductor substrate S1 decreases. Thus, in the nonselected program memory cell 2, the depleted layer prevents a voltage difference large enough to cause the quantum tunneling effect from being generated between the memory gate electrode MG and the semiconductor substrate S1, thereby preventing charge injection into the charge storage layer EC.

In the nonselected program memory cell 2 in this state, the depleted layer formed in the semiconductor substrate S1 directly below the memory gate structure 5 prevents the potential at the surface of the semiconductor substrate S1 directly below the memory gate structure 5 from reaching at the first select gate insulating film 12a of the first select gate structure 6 and the second select gate insulating film 12b of the second select gate structure 7.

Accordingly, in the first select gate structure 6, when the thickness of the first select gate insulating film 12a is reduced in accordance with the low program voltage applied from the bit line BL to the drain region 8a and the first select gate line select voltage applied to the first select gate electrode DG, the potential of the semiconductor substrate S1 directly below the memory gate structure 5 is blocked by the depleted layer and thus prevented from causing dielectric breakdown to the first select gate insulating film 12a.

In the second select gate structure 7, when the thickness of the second select gate insulating film 12b is reduced in accordance with the low source off voltage applied from the source line SL to the source region 8b and the gate off voltage applied to the second select gate electrode SG, the potential of the semiconductor substrate S1 directly below the memory gate structure 5 is blocked by the depleted layer and thus prevented from causing dielectric breakdown to the second select gate insulating film 12b.

### (1-1-3) Operation of read memory cell

In data reading operation of the memory cell 2, a read voltage is set to be the power supply voltage Vdd (for example, a voltage larger than 0 V and equal to or smaller than 1.5 V), the bit line BL is precharged to the power supply voltage Vdd, the source voltage is set to be the reference voltage Vss (for example, a voltage of 0 V), and the source line SL is set to be the reference voltage Vss. When charge is stored in the charge storage layer

EC of the memory cell (read memory cell) 2 from which data is to be read (when data is programmed), the semiconductor substrate S1 directly below the memory gate structure 5 is in a non-conductive state, blocking electrical connection between the drain region 8a and the source region 8b. Accordingly, in the memory cell 2 from which data is to be read, the read voltage at the power supply voltage Vdd is maintained intact at the bit line BL connected with the drain region 8a.

When no charge is stored in the charge storage layer EC of the read memory cell 2 (when no data is programmed), the semiconductor substrate S1 directly below the memory gate structure 5 is in a conductive state, electrically connecting the drain region 8a and the source region 8b. As a result, the source line SL at the reference voltage Vss and the bit line BL at the power supply voltage Vdd are electrically connected with each other through the memory cell 2. Accordingly, in the non-volatile semiconductor memory device 1, the read voltage at the power supply voltage Vdd decreases at the bit line BL connected with the read memory cell 2.

Thus, in the non-volatile semiconductor memory device 1, data reading operation to determine whether charge is stored in the charge storage layer EC of the memory cell 2 can be executed by detecting whether the read voltage applied to the bit line BL has changed. A nonselect read voltage at the reference voltage Vss same as the source voltage is applied to the bit line BL connected only with the memory cell (nonselected read memory cell) 2 from which no data is to be read.

### (1-1-4) Operation of erase memory cell

In data erasing operation to remove charge from the charge storage layer EC of the memory cell 2, an erase gate voltage Verase (for example, -12 V) is applied from the memory gate line ML to the memory gate electrode MG so that charge inside the charge storage layer EC is removed to the semiconductor substrate S1 at the reference voltage Vss (for example, a voltage of 0 V) as a substrate voltage, thereby achieving a data erased state.

### (1-2) Charge pump circuit

In addition to the above-described configuration, the non-volatile semiconductor memory device 1 is provided with the Dixon charge pump circuit 4 including a plurality of capacitive elements C1, C2, ... and a plurality of PN junction diodes D1, D2, D3, .... FIG. 1 illustrates, for example, a sectional configuration of a region in which the two capacitive elements C1 and C2 are disposed. The capacitive element C1 is disposed between the PN junction diodes D1 and D2, and the capacitive element C2 is disposed between the PN junction diodes D2 and D3. The following description will be mainly made on the capacitive element C1, but not on the capacitive element C2 having a basic configuration same as that of the capacitive element C1 to avoid any duplicate description.

As illustrated in FIG. 1 of the sectional configuration at a certain position, the capacitive element C1 has a configuration in which a capacitor sidewall electrode 19a and a capacitor electrode structure 16a are sequentially and alternately arranged, and in addition, a wall-shaped capacitive sidewall insulating film 21 is provided between the capacitor sidewall electrode 19a and the capacitor electrode structure 16a. A plurality of the capacitor electrode structures 16a having identical configurations are disposed at predetermined intervals on an insulating layer IS. Each capacitor electrode structure 16a has a configuration in which a charge storage layer ECa and an insulating film 11a are sequentially stacked on the insulating layer IS, and in addition, a capacitor electrode 17a is provided on the insulating film 11a. The capacitor electrode 17a is formed through a manufacturing process of forming the memory gate electrode MG of the memory cell 2, and thus is made of a layer same as that of the memory gate electrode MG.

The charge storage layer ECa provided in the capacitor electrode structure 16a is formed through a manufacturing process of forming the charge storage layer EC of the memory cell 2, and thus is made of a layer same as that of the charge storage layer EC. The insulating film 11a provided on the capacitor electrode structure 16a is formed through a manufacturing process of forming the upper memory gate insulating film 11 of the memory cell 2, and thus is made of a layer same as that of the upper memory gate insulating film 11.

In addition to the above-described configuration, the capacitor electrode structure 16a includes the capacitive sidewall insulating film 21 wall-shaped along the first sidewall, and the capacitor sidewall electrode 19a along the capacitive sidewall insulating film 21. The capacitor electrode structure 16a also includes another capacitive sidewall insulating film 21 wall-shaped along a second sidewall facing to the first sidewall, and another capacitor sidewall electrode 19a along the capacitive sidewall insulating film 21.

Each capacitive sidewall insulating film 21 is formed through a manufacturing process of forming the sidewall spacers 13a and 13b of the memory cell 2, and thus is made of a layer same as that of the sidewall spacers 13a and 13b. Thus, the capacitive sidewall insulating film 21 includes no charge storage layer ECa, and is made only of an insulating material such as oxide silicon (SiO or SiO₂) having a film quality same as those of the sidewall spacers 13a and 13b. The thickness of the capacitive sidewall insulating film 21 is set to be 5 nm to 40 nm inclusive in accordance with the thicknesses of the sidewall spacers 13a and 13b.

In the present embodiment, the capacitive sidewall insulating films 21 are formed along the sidewalls of each capacitor electrode structure 16a simultaneously with formation of the sidewall spacers 13a and 13b of the memory cell 2 by CVD, and thus are made of a layer same as that of the sidewall spacers 13a and 13b. Accordingly, the capacitive sidewall insulating films 21 have excellent film qualities and high breakdown voltages as compared to those of an oxide film formed by thermally oxidizing polysilicon, and can be highly freely designed to have thicknesses without restriction due to consumption of polysilicon through the thermal oxidation.

The capacitive sidewall insulating films 21 are formed as layers independent and different from those of the lower memory gate insulating film 10, the charge storage layer EC, the upper memory gate insulating film 11, the first select gate insulating film 12a, and the second select gate insulating film 12b, the thicknesses and film qualities of which are restricted to optimize programming operation, reading operation, and erasing operation of the memory cell 2. Thus, the thicknesses and film qualities of the capacitive sidewall insulating films 21 are free from the restriction and thus can be set mainly for the breakdown voltage between the capacitor electrode structure 16a (16b) and the capacitor sidewall electrode 19a (19b).

Each capacitor sidewall electrode 19a disposed along the corresponding capacitive sidewall insulating film 21 is formed through a manufacturing process of forming the first select gate electrode DG and the second select gate electrode SG of the memory cell 2, and thus is made of a layer same as that of the first select gate electrode DG and the second select gate electrode SG.

In the capacitive element C1, the capacitor sidewall electrode 19a between the capacitor electrode structures 16a adjacent to each other fills a gap between the capacitive sidewall insulating films 21 facing to each other between the adjacent capacitor electrode structures 16a. In the capacitive element C1, an opposite-conductivity-type junction part 15a of the PN junction diode D1 is disposed along the capacitive sidewall insulating film 21 of the capacitor electrode structure 16a at an end not adjacent to the capacitive element C2.

An opposite-conductivity-type junction part 15b of the PN junction diode D2 is disposed between the capacitive elements C1 and C2 adjacent to each other to fill a gap between the capacitive sidewall insulating film 21 of the capacitive element C1 and the capacitive sidewall insulating film 21 of the capacitive element C2. In addition, an opposite-conductivity-type junction part 15c of the PN junction diode D3 is disposed between the capacitive element C2 and another capacitive element (not illustrated) adjacent to each other.

The opposite-conductivity-type junction parts 15a, 15b, and 15c are made of an opposite-conductivity-type semiconductor material having a conductivity type different from that of the capacitor electrodes 17a and 17b and the capacitor sidewall electrodes 19a and 19b. The PN junction diodes D1, D2, and D3 to be described later are disposed in regions adjacent to the capacitive elements C1, C2, .... In the present embodiment, the capacitor electrodes 17a and 17b and the capacitor sidewall electrodes 19a and 19b are made of an N-type semiconductor material, and the opposite-conductivity-type junction parts 15a, 15b, and 15c are made of a P-type semiconductor material.

The opposite-conductivity-type junction parts 15a, 15b, and 15c are made of a layer same as that of the capacitor sidewall electrodes 19a and 19b, and formed by doping, through ion implantation in a manufacturing process, P-type impurities to the capacitor sidewall electrodes 19a and 19b and a semiconductor material remaining after formation of an input electrode 24a and an output electrode 24b to be described later.

The capacitive element C2 is disposed between the opposite-conductivity-type junction parts 15b and 15c unlike the capacitive element C1 described above, but a capacitor electrode structure 16b and a capacitor sidewall electrode 19b have configurations same as those of the capacitor electrode structure 16a and the capacitor sidewall electrode 19a, respectively, of the capacitive element C1 described above.

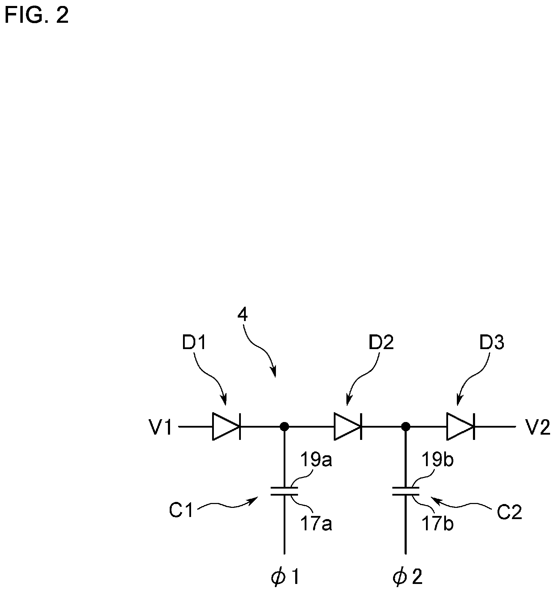

The following describes the Dixon charge pump circuit 4 having a specific configuration in which the two capacitive elements C1 and C2 and the three PN junction diodes D1, D2, and D3 are provided as illustrated in FIG. 2. In this case, as illustrated in FIG. 2, in the Dixon charge pump circuit 4 in which the two capacitive elements C1 and C2 and the three PN junction diodes D1, D2, and D3 are provided, the PN junction diodes D1, D2, and D3 between the input electrode and the output electrode are connected in series, the cathode of the PN junction diode D1 is connected with the capacitor sidewall electrode 19a of the capacitive element C1 and the anode of the PN junction diode D2, and the cathode of the PN junction diode D2 is connected with the capacitor sidewall electrode 19b of the capacitive element C2 and the anode of the PN junction diode D3.

In this example, an input voltage V1 is applied to the anode of the PN junction diode D1, voltage of a first clock φ1 is applied to the capacitor electrode 17a of the capacitive element C1 as an odd-numbered stage, and voltage of a second clock φ2 having a phase opposite to that of the first clock φ1 is applied to the capacitor electrode 17b of the capacitive element C2 as an even-numbered stage. The capacitive elements C1 and C2 repeat charging and discharging at the timings of voltage change between high and low levels at the first clock φ1 and the second clock φ2. The charge pump circuit 4 outputs, as the output voltage V2 from the output electrode, a voltage obtained by multiplying a voltage having the amplitude of the first clock φ1 or the second clock φ2 by the number of stages of the capacitive elements C1 and C2.

The charge pump circuit 4 can be used as a negative booster circuit. When the charge pump circuit 4 is used as a negative booster circuit, an input voltage is applied to the output electrode, voltage of the first clock φ1 is applied to the capacitive element C1, and voltage of the second clock φ2 having a phase opposite to that of the first clock φ1 is applied to the capacitive element C2. Accordingly, the capacitive elements C1 and C2 repeat charging and discharging at the timings of voltage change between high and low levels of the first clock φ1 and the second clock φ2. The charge pump circuit 4 outputs, as an output voltage from the input electrode, a negative voltage (for example, -12 V) obtained by multiplying a voltage having the amplitude of the first clock φ1 or the second clock φ2 by the number of stages of the capacitive elements C1 and C2. The negative voltage generated by the charge pump circuit 4 can be used at data erasing operation to remove charge from the charge storage layer EC of the memory cell 2.

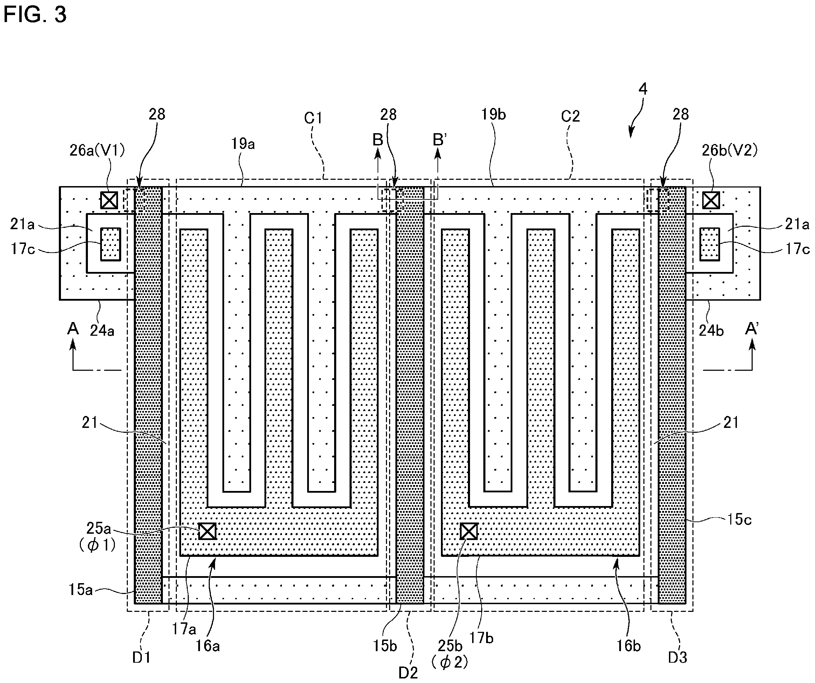

FIG. 3 is a schematic diagram of a planar layout of the charge pump circuit 4 illustrated in FIG. 2, mainly illustrating the capacitor electrodes 17a and 17b, the capacitor sidewall electrodes 19a and 19b, the opposite-conductivity-type junction parts 15a, 15b, and 15c, the capacitive sidewall insulating film 21, the input electrode 24a, and the output electrode 24b in FIG. 1. The sectional configuration of the charge pump circuit 4 in FIG. 1 is taken along line A-A' in FIG. 3. As illustrated in FIG. 3, the capacitive elements C1 and C2 and the PN junction diodes D1, D2, and D3 are alternately arranged in the charge pump circuit 4 such that the PN junction diode D1 is disposed between the input electrode 24a and the capacitive element C1, the PN junction diode D2 is disposed between the capacitive element C1 and the capacitive element C2, the PN junction diode D3 is disposed between the capacitive element C2 and the output electrode 24b.

The capacitive element C1 includes the comb-teeth shaped capacitor electrode structure 16a, the capacitive sidewall insulating film 21 wall-shaped along a sidewall of the capacitor electrode structure 16a, and the capacitor sidewall electrode 19a disposed along a sidewall of the capacitive sidewall insulating film 21. In the present embodiment, a contact 25a is provided at a certain position on the capacitor electrode structure 16a to allow voltage application of the first clock φ1 to the capacitor electrode 17a through the contact 25a.

The capacitive sidewall insulating film 21 is disposed across the entire sidewall of the capacitor electrode structure 16a, meandering along the comb-teeth shape of the capacitor electrode structure 16a at a comb-teeth shaped part of the capacitor electrode structure 16a. The capacitor sidewall electrode 19a is comb-teeth shaped at a meandering part of the capacitive sidewall insulating film 21 and disposed in a void space between facing parts of the capacitive sidewall insulating film 21. In this manner, in the capacitive element C1, the capacitive sidewall insulating film 21 meanders between the capacitor electrode structure 16a and the capacitor sidewall electrode 19a to have an increased area so that a large capacitance can be obtained in a limited region.

In the above-described embodiment, the capacitive sidewall insulating film 21 is formed in a meandering shape in accordance with the comb-teeth shape of the capacitor electrode structure 16a, but the present invention is not limited thereto. The area of the capacitive sidewall insulating film 21 disposed between the capacitor electrode structure 16a and the capacitor sidewall electrode 19a may be increased by, for example, forming the capacitor electrode structure 16a in a meandering shape and the capacitive sidewall insulating film 21 in a meandering shape along the capacitor electrode structure 16a, or forming the capacitor electrode structure 16a in a spiral shape and the capacitive sidewall insulating film 21 in a spiral shape along the capacitor electrode structure 16a.

The PN junction diode D2, which is disposed between the capacitive element C1 and the capacitive element C2, includes the opposite-conductivity-type junction part 15b and a conduction part 28 to be described later. The opposite-conductivity-type junction part 15b is disposed between the facing capacitive sidewall insulating films 21 in a region across which the capacitive element C1 and the capacitive element C2 are adjacent to each other. The opposite-conductivity-type junction part 15b is joined with the capacitor sidewall electrode 19a of the capacitive element C1 and the capacitor sidewall electrode 19b of the capacitive element C2. The capacitor sidewall electrodes 19a and 19b are each made of an N-type semiconductor material (for example, N-type polysilicon), and the opposite-conductivity-type junction part 15b is made of a P-type semiconductor material (for example, P-type polysilicon). Accordingly, the capacitor sidewall electrode 19a, the opposite-conductivity-type junction part 15b, and the capacitor sidewall electrode 19b form an NPN junction structure.

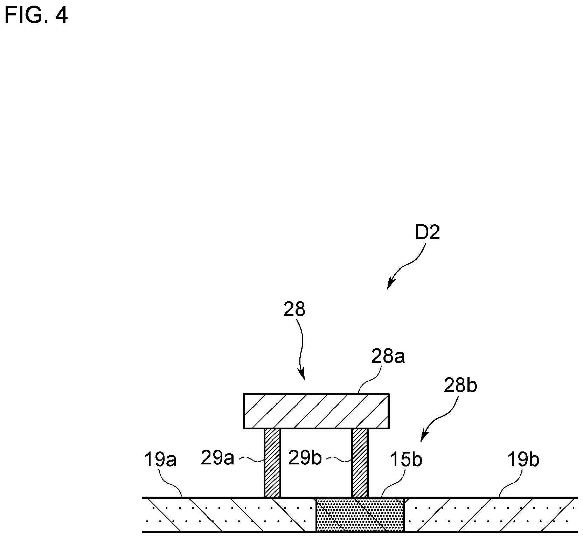

As illustrated in FIG. 4 of a sectional configuration taken along line B-B' in FIG. 3, the capacitor sidewall electrode 19a of the capacitive element C1 at the pre-stage and the opposite-conductivity-type junction part 15b are electrically connected with each other through the conduction part 28 made of, for example, a metallic material. The conduction part 28 includes a first contact 29a provided on the capacitor sidewall electrode 19a of the capacitive element C1, a second contact 29b provided on the opposite-conductivity-type junction part 15b, and a connection part 28a connecting the first contact 29a and the second contact 29b. The capacitor sidewall electrode 19a of the capacitive element C1 at the pre-stage is electrically connected with the opposite-conductivity-type junction part 15b through the first contact 29a, the connection part 28a, and the second contact 29b. In this example, the PN junction diode D2 has a configuration in which the capacitor sidewall electrode 19a is electrically connected with the opposite-conductivity-type junction part 15b (in other words, an NP junction structure of the NPN junction structure is achieved through electrical connection), and a PN junction part 28b obtained by joining the opposite-conductivity-type junction part 15b and the capacitor sidewall electrode 19b.

In the present embodiment, as illustrated in FIG. 3, the opposite-conductivity-type junction part 15b is formed, between the capacitive elements C1 and C2 adjacent to each other, in a strip shape filling a gap between the capacitive sidewall insulating films 21 facing to each other and extending side by side. The capacitor sidewall electrode 19a of the capacitive element C1 at the pre-stage and the capacitor sidewall electrode 19b of the capacitive element C2 at the post-stage, facing to each other, are joined with sidewalls of the opposite-conductivity-type junction part 15b at end parts, which are not joined with the capacitive sidewall insulating films 21.

The formed NPN junction structure electrically separates the capacitor sidewall electrode 19a of the capacitive element C1 at the pre-stage from the capacitor sidewall electrode 19b of the capacitive element C2 at the post-stage, where the conduction part 28 is not provided in a junction region in which the capacitor sidewall electrode 19a of the capacitive element C1 at the pre-stage, the opposite-conductivity-type junction part 15a, and the capacitor sidewall electrode 19b of the capacitive element C2 at the post-stage are joined with each other.

As illustrated in FIG. 3, similarly to the capacitive element C1 at the pre-stage, the capacitive element C2 at the post-stage includes a comb-teeth shaped capacitor electrode structure 16b and the capacitive sidewall insulating film 21 wall-shaped along a sidewall of the capacitor electrode structure 16b. In the present embodiment, the capacitive element C2 at the post-stage is disposed between the opposite-conductivity-type junction parts 15b and 15c of the PN junction diodes D2 and D3. The capacitor sidewall electrode 19b formed in accordance with the comb-teeth shape of the capacitor electrode structure 16b is provided between the opposite-conductivity-type junction parts 15b and 15c.

In the present embodiment, a contact 25b is provided at a certain position on the capacitor electrode structure 16b of the capacitive element C2 at the post-stage to allow voltage application of the second clock φ2 having a phase opposite to that of the first clock φ1 to the capacitor electrode 17b through the contact 25b. The capacitive element C2 at the post-stage is provided with the output electrode 24b through the PN junction diode D3. The input electrode 24a and the output electrode 24b are each made of, for example, an N-type semiconductor material (for example, N-type polysilicon). The input voltage V1 is applied to the input electrode 24a through an input contact 26a. An output contact 26b connected with the memory gate line is provided at a certain position on the output electrode 24b.

The input electrode 24a and the output electrode 24b are each provided along a wall-shaped dummy insulating film 21a provided around a dummy electrode structure 17c. The dummy electrode structure 17c is formed through a manufacturing process of forming the capacitor electrode structures 16a and 16b and thus made of a layer same as that of the capacitor electrode structures 16a and 16b. Thus, similarly to the capacitor electrode structures 16a and 16b, the dummy electrode structure 17c has a configuration in which a charge storage layer, an insulating film, and an electrode are sequentially stacked on an insulating layer. The dummy insulating film 21a is formed along a sidewall of the dummy electrode structure 17c through a manufacturing process of forming the capacitive sidewall insulating film 21 and thus made of a layer same as that of the capacitive sidewall insulating film 21. Similarly to the capacitive sidewall insulating film 21, the dummy insulating film 21a is made of an insulating material such as oxide silicon (SiO or SiO₂) only.

In the present embodiment, the dummy electrode structure 17c and the dummy insulating film 21a are provided to allow a semiconductor material to remain around the dummy insulating film 21a through etching back in a manufacturing process so that the remaining semiconductor material is used as the input electrode 24a or the output electrode 24b.

The PN junction diodes D1 and D3 each have a configuration same as that of the PN junction diode D2 described above. Specifically, in the PN junction diode D1, the input electrode 24a and the opposite-conductivity-type junction part 15a are electrically connected with each other through the conduction part 28 (the NP junction structure of an NPN junction structure is achieved through electrical connection). The PN junction diode D1 includes a PN junction part in a region in which the opposite-conductivity-type junction part 15a and the capacitor sidewall electrode 19a are joined with each other. In the PN junction diode D3, the capacitor sidewall electrode 19b and the opposite-conductivity-type junction part 15c are electrically connected with each other through the conduction part 28 (the NP junction structure of an NPN junction structure is achieved through electrical connection). The PN junction diode D3 includes a PN junction part in a region in which the opposite-conductivity-type junction part 15c and the output electrode 24b are joined with each other.

The charge pump circuit 4 having the above-described configuration applies the output voltage V2 increased at the capacitive elements C1 and C2 to the memory gate electrode MG of the memory cell 2 sequentially through the output contact 26b provided on the output electrode 24b and the memory gate line.

The non-volatile semiconductor memory device 1 having such a configuration can be formed through a typical semiconductor manufacturing process using a photolithography technique, a deposition technology such as oxidation or CVD, an etching technology, and an ion implantation method, and thus description thereof will be omitted in the following.

In the above-described embodiment, the conduction part 28 including the first contact 29a, the connection part 28a, and the second contact 29b is provided as a conduction part, but the present invention is not limited thereto. For example, a silicide layer formed across the surface of the capacitor sidewall electrode 19a of the capacitive element C1 and the surface of the opposite-conductivity-type junction part 15b may be provided as a conduction part.

In this case, another silicide layer may be provided on the surface of the capacitor sidewall electrode 19b of the capacitive element C2, and a gap may be provided to prevent the other silicide layer from contacting with the silicide layer provided as a conduction part as described above on an upper surface of the PN junction part 28b. Alternatively, one contact may be provided as a conduction part across the surface of the capacitor sidewall electrode 19a of the capacitive element C1 and the surface of the opposite-conductivity-type junction part 15b.

In the above-described embodiment, the opposite-conductivity-type junction parts 15a, 15b, and 15c extending in strip shapes are each provided along a sidewall of the capacitive sidewall insulating film 21, but the present invention is not limited thereto. For example, an opposite-conductivity-type junction part may be provided only in a region in which the input electrode 24a faces to the capacitor sidewall electrode 19a of the capacitive element C1, a region in which the capacitor sidewall electrode 19a of the capacitive element C1 faces to the capacitor sidewall electrode 19b of the capacitive element C2, or a region in which the capacitor sidewall electrode 19b of the capacitive element C2 faces to the output electrode 24b. Alternatively, in an example not forming part of the claimed invention, no opposite-conductivity-type junction part and thus no junction part made of a semiconductor material may be provided, but instead, a physical disconnection part disconnecting the capacitor sidewall electrodes 19a and 19b from each other may be provided where the conduction part 28 is not provided in the region in which the capacitor sidewall electrode 19a of the capacitive element C1 faces to the capacitor sidewall electrode 19b of the capacitive element C2.

### (2) Operations and effects

In the non-volatile semiconductor memory device 1 having the above-described configuration, the charge pump circuit 4 is provided on the insulating layer IS of the semiconductor substrate S1 on which the memory cell 2 is provided, and the capacitive sidewall insulating film 21 between the capacitor sidewall electrode 19a (19b) and the capacitor electrode 17a (17b) of the capacitive element C1, C2 in the charge pump circuit 4 is made of a layer same as that of the sidewall spacers 13a and 13b of the memory cell 2.

In the non-volatile semiconductor memory device 1, the charge storage gate voltage Vprog that is high enough to allow charge injection into the charge storage layer EC of the memory cell 2 by the quantum tunneling effect is generated by the charge pump circuit 4 and applied to the memory gate electrode MG of the memory cell 2 through the memory gate line ML.

In the non-volatile semiconductor memory device 1, the capacitive sidewall insulating films 21 of the capacitive elements C1 and C2 are made of a layer same as that of the sidewall spacers 13a and 13b of the memory cell 2, the film qualities and thicknesses of which are adjusted mainly for breakdown voltage. The configuration leads to improved breakdown voltage characteristics and stabilized capacitor characteristics of the capacitive elements C1 and C2 as compared to a conventional capacitive element in which a silicon nitride film is provided in a capacitive insulating film. The non-volatile semiconductor memory device 1 does not need a conventionally needed power supply for achieving low voltage application to a capacitive element, thereby achieving a simplified and downsized configuration accordingly.

In the non-volatile semiconductor memory device 1, for example, the high charge storage gate voltage Vprog can be generated by increasing the power supply voltage Vdd (for example, a voltage larger than 0 V and equal to or smaller than 1.5 V) at the charge pump circuit 4. Thus, a single power supply of the power supply voltage Vdd can be used in the non-volatile semiconductor memory device 1.

### (3) Charge pump circuit including four capacitive elements

In the above-described embodiment, the Dixon charge pump circuit 4 including the two capacitive elements C1 and C2 is employed, but the present invention is not limited thereto. A Dixon charge pump circuit including a plurality (for example, three or four) of capacitive elements may be employed. The following describes, for example, a planar layout of a Dixon charge pump circuit according to the present invention including four capacitive elements.

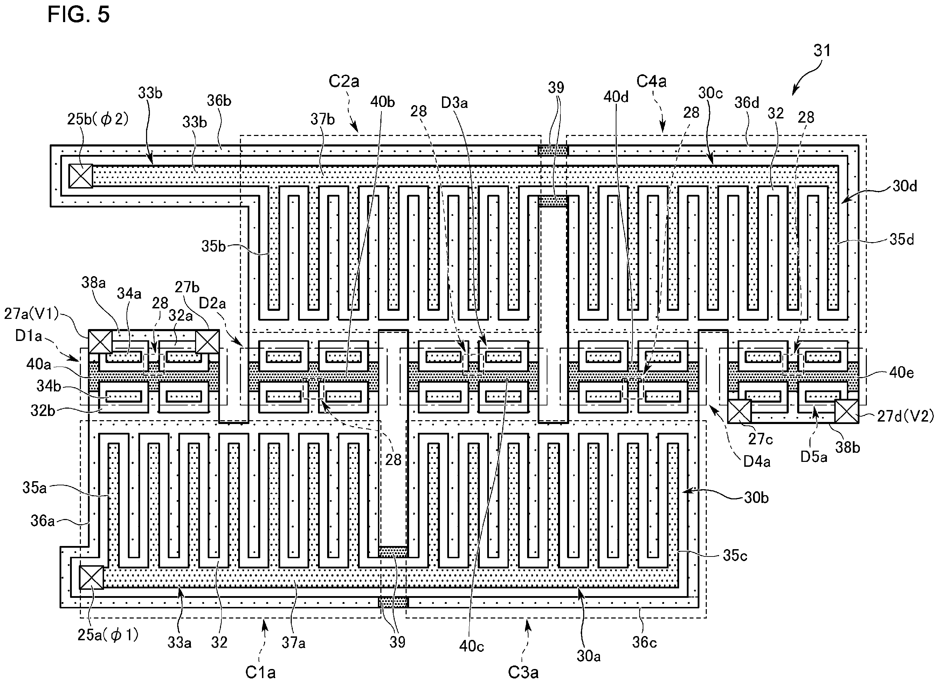

FIG. 5 is a schematic view illustrating a planar layout of a Dixon charge pump circuit 31 including four capacitive elements C1a, C2a, C3a, and C4a and five PN junction diodes D1a, D2a, D3a, D4a, and D5a. As illustrated in FIG. 5, in the charge pump circuit 31, the capacitive elements C1a and C3a at odd-numbered stages, to which a voltage of the first clock φ1 is applied, are arranged in one direction. In addition, in the charge pump circuit 31, the capacitive elements C2a and C4a at even-numbered stages, to which a voltage of the second clock φ2 having a phase opposite to that of the first clock φ1 is applied, are arranged in one direction and extend side by side with the capacitive elements C1a and C3a.

The plurality of PN junction diodes D1a, D2a, D3a, D4a, and D5a are arranged in one direction between the capacitive elements C1a and C3a at odd-numbered stages arranged in one direction and the capacitive elements C2a and C4a at even-numbered stages arranged in one direction. In the charge pump circuit 31, an input electrode 38a is provided adjacent to an opposite-conductivity-type junction part 40a of the PN junction diode D1a at the first stage disposed at one end of the charge pump circuit 31, and input contacts 27a and 27b, to which the input voltage V1 is applied, are provided on the input electrode 38a.

The PN junction diode D1a at the first stage includes a pair of dummy electrode structures 34a and 34b spaced at a certain distance, and wall-shaped dummy insulating films 32a and 32b provided along sidewalls of the dummy electrode structures 34a and 34b. In the present embodiment, the PN junction diode D1a includes a plurality of the dummy electrode structures 34a arranged at intervals in one direction and a plurality of the dummy electrode structures 34b arranged at intervals in one direction, the dummy electrode structures 34b being paired with the respective dummy electrode structures 34a.

The dummy electrode structures 34a and 34b and the dummy insulating films 32a and 32b are also provided on the other PN junction diodes D2a, D3a, D4a, and D5a, but the following description will be made mainly on the dummy electrode structures 34a and 34 and the dummy insulating films 32a and 32b provided on the PN junction diode D1a at the first stage. In this case, the dummy electrode structures 34a and 34 are formed through a manufacturing process of forming common capacitor electrode bodies 33a and 33b to be described later, and thus made of a layer same as that of the common capacitor electrode bodies 33a and 33b. Accordingly, similarly to the common capacitor electrode bodies 33a and 33b, the dummy electrode structures 34a and 34b each have a configuration in which a charge storage layer, an insulating film, and an electrode are sequentially stacked on an insulating layer.

The dummy insulating films 32a and 32b are formed along sidewalls of the dummy electrode structures 34a and 34b through a manufacturing process of forming a capacitive sidewall insulating film 32 to be described later, and thus made of a layer same as that of the capacitive sidewall insulating film 32. Accordingly, similarly to the capacitive sidewall insulating film 32, the dummy insulating films 32a and 32b include no charge storage layer and are only made of an insulating material such as oxide silicon (SiO or SiO₂) having a film quality same as that of the capacitive sidewall insulating film 32.

In the present embodiment, the dummy electrode structures 34a and 34 are disposed so that, through etching back in a manufacturing process, a semiconductor material remains and fills any gap between the dummy insulating films 32a (32b) around the respective dummy electrode structures 34a (34b) arranged in one direction, and any gap between the dummy insulating films 32a and 32b around the dummy electrode structures 34a and 34b arranged in parallel. The remaining semiconductor material in the PN junction diodes D1a, D2a, D3a, D4a, and D5a serves as the input electrodes 38a, capacitor sidewall electrodes 36a and 36b, and the like, and also serves as opposite-conductivity-type junction parts 40a and 40b and the like through doping with P-type impurities in predetermined regions. Thus, the opposite-conductivity-type junction parts 40a and 40b and the like are made of a layer same as that of the input electrode 38a, the capacitor sidewall electrodes 36a and 36b, and the like.

In the PN junction diode D1a, the opposite-conductivity-type junction part 40a is provided in a region in which the dummy insulating films 32a of the dummy electrode structures 34a arranged in one direction face to the dummy insulating films 32b of the dummy electrode structures 34b arranged in one direction. The opposite-conductivity-type junction part 40a disconnects the input electrode 38a disposed closer to the dummy electrode structures 34a from the capacitor sidewall electrode 36a of the capacitive element C1a disposed closer to the dummy electrode structures 34b.

In the present embodiment, the input electrode 38a is disposed along a sidewall of the dummy insulating film 32a around each dummy electrode structure 34a, and has a sidewall shape having a gradually increasing tilt toward the surface of the substrate from the top portion thereof. The input contacts 27a and 27b each extend from the input electrode 38a over the dummy insulating film 32a and the dummy electrode structure 34a. With the configuration, the input contacts 27a and 27b each have an increased installation area due to the dummy insulating film 32a and the dummy electrode structure 34a, and allow reliable application of the input voltage V1 to the input electrode 38a having a narrow width.

The PN junction diode D1a, which is provided between the input electrode 38a and the capacitive element C1a, includes the opposite-conductivity-type junction part 40a and the conduction part 28. The input electrode 38a is electrically connected with the opposite-conductivity-type junction part 40a through the conduction part 28. Since the input electrode 38a and the capacitor sidewall electrode 36a are each made of an N-type semiconductor material (for example, N-type polysilicon), and the opposite-conductivity-type junction part 40a is made of P-type semiconductor material (for example, P-type polysilicon), an NPN junction structure is formed by the input electrode 38a, the opposite-conductivity-type junction part 40a, and the capacitor sidewall electrode 36a. The PN junction diode D1a includes a PN junction part at which the opposite-conductivity-type junction part 40a is joined with the capacitor sidewall electrode 36a.

The capacitive elements C1a and C3a at odd-numbered stages each include a common capacitor electrode body 33a common to the capacitive elements C1a and C3a. A voltage of the first clock φ1 is applied to the common capacitor electrode body 33a through the contact 25a provided at a certain position on the common capacitor electrode body 33a. The common capacitor electrode body 33a has a configuration in which a charge storage layer, an insulating film, and a capacitor electrode 37a are sequentially stacked on an insulating layer. The common capacitor electrode body 33a includes a comb-teeth shaped capacitor electrode structure 35a disposed in a formation region of the capacitive element C1a at the first stage, and a comb-teeth shaped capacitor electrode structure 35c disposed in a formation region of the capacitive element C3a at the third stage.

The capacitive element C1a (C3a) includes the comb-teeth shaped capacitor electrode structure 35a (35c), the wall-shaped capacitive sidewall insulating film 32 disposed along a sidewall of the capacitor electrode structure 35a (35c), and the capacitor sidewall electrode 36a (36c) disposed along a sidewall of the capacitive sidewall insulating film 32. The capacitive sidewall insulating film 32 is disposed across the entire sidewall of the common capacitor electrode body 33a, and thus continuously provided without disconnection across the sidewall of the capacitor electrode structure 35a disposed on the capacitive element C1a at the first stage and the sidewall of the capacitor electrode structure 35a disposed on the adjacent capacitive element C3a at the third stage.

In the capacitive elements C1a and C3a, the capacitive sidewall insulating film 32 is disposed in a meandering shape in accordance with the comb-teeth shapes of the capacitor electrode structures 35a and 35c, and the capacitor sidewall electrodes 36a and 36c each have a comb-teeth shaped part in accordance with the meandering shape of the capacitive sidewall insulating film 32. Electrical connection between the capacitor sidewall electrodes 36a and 36c is disconnected by a disconnection part 39. In the present embodiment, the disconnection part 39 is provided between the capacitive elements C1a and C3a and made of an opposite-conductivity-type (in this case, P-type) semiconductor material having a conductivity type different from that of the capacitor sidewall electrodes 36a and 36c. Accordingly, the disconnection part 39 forms an NPN junction structure in a junction region between the capacitive elements C1a and C3a, thereby disconnecting electrical connection between the capacitor sidewall electrodes 36a and 36c. The disconnection part 39 is made of a layer same as that of the opposite-conductivity-type junction parts 40a and 40b and the like and formed simultaneously when the opposite-conductivity-type junction parts 40a and 40b and the like are formed by, for example, ion implantation in a manufacturing process.

The PN junction diode D2a at the second stage is provided between the capacitive element C1a at the first stage and the capacitive element C2a at the second stage facing to the capacitive element C1a. The opposite-conductivity-type junction part 40b of the PN junction diode D2a is provided between the capacitor sidewall electrode 36a of the capacitive element C1a at the first stage and the capacitor sidewall electrode 36b of the capacitive element C2a at the second stage. Similarly to the above-described PN junction diode D1a at the first stage, the PN junction diode D2a at the second stage is provided with the wall-shaped dummy insulating films 32a and 32b along sidewalls of the dummy electrode structures 34a and 34b. Description thereof will be omitted in the following.

The PN junction diode D2a at the second stage, which is provided between the capacitive element C1a at the first stage and the capacitive element C2a at the second stage, includes the opposite-conductivity-type junction part 40b and the conduction part 28. The conduction part 28 electrically connects the opposite-conductivity-type junction part 40a with the capacitor sidewall electrode 36a of the capacitive element C1a at the first stage. Similarly to the above-described PN junction diode D1a at the first stage, the capacitor sidewall electrode 36a, the opposite-conductivity-type junction part 40a, and the capacitor sidewall electrode 36b form an NPN junction structure in the PN junction diode D2a at the second stage. The NPN junction structure includes a PN junction part at which the opposite-conductivity-type junction part 40a is joined with the capacitor sidewall electrode 36a.

In the capacitive elements C2a and C4a at even-numbered stages, a common capacitor electrode body 33b common to the capacitive elements C2a and C4a is provided to allow voltage application of the second clock φ2 having a phase opposite to that of the first clock φ1 to the common capacitor electrode body 33b through the contact 25b provided at a certain position on the common capacitor electrode body 33b. The common capacitor electrode body 33b has a configuration in which a charge storage layer, an insulating film, and a capacitor electrode 37b are sequentially stacked on an insulating layer. The common capacitor electrode body 33b includes a comb-teeth shaped capacitor electrode structure 35b disposed in a formation region of the capacitive element C2a at the second stage, and a comb-teeth shape capacitor electrode structure 35d disposed in a formation region of the capacitive element C4a at the fourth stage.

In the present embodiment, a straight extension part 30a on the common capacitor electrode body 33a provided across the capacitive elements C1a and C3a at odd-numbered stages extends in one direction side by side with a straight extension part 30c on the common capacitor electrode body 33b provided across the capacitive elements C2a and C4a at even-numbered stages. Comb-teeth shaped parts 30b and 30d of the respective common capacitor electrode bodies 33a and 33b are disposed in a region sandwiched between the extension part 30a of the common capacitor electrode body 33a and the extension part 30c of the common capacitor electrode body 33b.

The capacitive element C2a (C4a) includes the comb-teeth shaped capacitor electrode structure 35b (35d), the wall-shaped capacitive sidewall insulating film 32 disposed along the sidewall of the capacitor electrode structure 35b (35d), and the capacitor sidewall electrode 36b (36d) disposed along the sidewall of the capacitive sidewall insulating film 32. The capacitive sidewall insulating film 32 is continuously provided without disconnection across the entire sidewall of the common capacitor electrode body 33b.

Similarly to the above-described capacitive elements C1a and C3a at odd-numbered stages, in the capacitive elements C2a and C4a at even-numbered stages, the capacitive sidewall insulating film 32 is formed in a meandering shape in accordance with the comb-teeth shapes of the capacitor electrode structures 35b and 35d, and the capacitor sidewall electrodes 36b and 36d each have a comb-teeth shaped part in accordance with the meandering shape of the capacitive sidewall insulating film 32. Electrical connection between the capacitor sidewall electrodes 36b and 36d is disconnected by the disconnection part 39.

Similarly to the above-described embodiment, the capacitive sidewall insulating film 32 disposed in each of the capacitive elements C1a, C2a, C3a, and C4a is formed through the manufacturing process of forming the sidewall spacers 13a and 13b of the memory cell 2 illustrated in FIG. 1, and made of a layer same as that of the sidewall spacers 13a and 13b. Thus, the capacitive sidewall insulating film 32 includes no charge storage layer, and is made of an insulating material such as oxide silicon (SiO or SiO₂) only having a film quality same as that of the sidewall spacers 13a and 13b. The thickness of the capacitive sidewall insulating film 32 is set to be 5 nm to 40 nm inclusive in accordance with the thicknesses of the sidewall spacers 13a and 13b.

The capacitive sidewall insulating film 32 is formed along the entire sidewalls of the common capacitor electrode bodies 33a and 33b when the sidewall spacers 13a and 13b of the memory cell 2 are formed by CVD, and made of a layer same as that of the sidewall spacers 13a and 13b. Accordingly, the capacitive sidewall insulating film 32 has an excellent film quality and high breakdown voltage as compared to those of an oxide film formed by thermally oxidizing polysilicon, and can be highly freely designed to have a thickness without restriction due to consumption of polysilicon through the thermal oxidation.

The capacitive sidewall insulating film 32 is formed as a layer independent and different from those of the lower memory gate insulating film 10, the charge storage layer EC, the upper memory gate insulating film 11, the first select gate insulating film 12a, and the second select gate insulating film 12b (FIG. 1), the thicknesses and film qualities of which are restricted to optimize programming operation, reading operation, and erasing operation of the memory cell 2. Thus, the thicknesses and film qualities of the capacitive sidewall insulating film 32 are free from the restriction and thus can be set mainly for breakdown voltage between the capacitor electrodes 37a and 37b and the capacitor sidewall electrodes 36a, 36b, 36c, and 36d.

The PN junction diode D3a at the third stage is provided between the capacitive element C2a at the second stage and the capacitive element C3a at the third stage facing to the capacitive element C2a. The PN junction diode D4a at the fourth stage is provided between the capacitive element C3a at the third stage and the capacitive element C4a at the fourth stage facing to the capacitive element C3a. Similarly to the above-described PN junction diodes D1a and D2a, the PN junction diode D3a (D4a) includes the conduction part 28 in a junction region between the capacitor sidewall electrode 36b (36c) at the pre-stage and an opposite-conductivity-type junction part 40c (40d), but includes a PN junction part, not the conduction part 28, in a junction region between the opposite-conductivity-type junction part 40c (40d) and the capacitor sidewall electrode 36c (36d) at the post-stage.

In the PN junction diode D5a at the last stage, an output electrode 38b is disconnected from the capacitor sidewall electrode 36d of the capacitive element C4a by an opposite-conductivity-type junction part 40e. The output electrode 38b is disposed along the sidewall of the dummy insulating film 32b around each dummy electrode structure 34b, and has a sidewall shape having a gradually increasing tilt toward the surface of the substrate from the top portion thereof. Output contacts 27c and 27d each extend from the output electrode 38b over the dummy insulating film 32b and the dummy electrode structure 34b. With the configuration, the output contacts 27c and 27d each have an increased installation area due to the dummy insulating film 32b and the dummy electrode structure 34b, and are electrically connected with the output electrode 38b having a narrow width.

The PN junction diode D5a at the last stage includes the conduction part 28 in a junction region between the capacitor sidewall electrode 36d of the capacitive element C4a and the opposite-conductivity-type junction part 40e, but includes a PN junction part, not the conduction part 28, in a junction region between the opposite-conductivity-type junction part 40e and the output electrode 38b.

With the above-described configuration, similarly to the non-volatile semiconductor memory device 1 illustrated in FIG. 1, in a non-volatile semiconductor memory device including the charge pump circuit 31 illustrated in FIG. 5, each capacitive sidewall insulating film 32 in the charge pump circuit 31 is made of a layer same as that of the sidewall spacers 13a and 13b of the memory cell 2. The configuration leads to improved breakdown voltage characteristics and stabilized capacitor characteristics of the capacitive elements C1a, C2a, C3a, and C4a as compared to a conventional capacitive element in which a silicon nitride film is provided in a capacitive insulating film. The charge pump circuit 31 does not need a conventionally needed power supply for achieving low voltage application, thereby achieving a simplified and downsized configuration accordingly.

The PN junction diodes D1a, D2a, D3a, D4a, and D5a in the charge pump circuit 31 each include the dummy electrode structures 34a and 34b. Accordingly, in the charge pump circuit 31, a semiconductor material remains around the dummy electrode structures 34a and 34b after the capacitor sidewall electrodes 36a, 36b, 36c, and 36d are formed of a semiconductor material by etching back in a manufacturing process. The remaining semiconductor material can be used to easily form the opposite-conductivity-type junction parts 40a, 40b, 40c, 40d, and 40e of the respective PN junction diodes D1a, D2a, D3a, D4a, and D5a.

In the above-described embodiment, in the charge pump circuit 31 illustrated in FIG. 5, the comb-teeth shaped parts 30b and 30d of the respective common capacitor electrode bodies 33a and 33b are provided in the region sandwiched between the extension part 30a of the common capacitor electrode body 33a and the extension part 30c of the common capacitor electrode body 33b, but the present invention is not limited thereto. The comb-teeth shaped parts 30b and 30d of the respective common capacitor electrode bodies 33a and 33b may be provided at various places other than the sandwiched region.

### (4) Non-volatile semiconductor memory device according to another embodiment

In the above-described embodiment, the memory gate electrode MG, the first select gate electrode DG, the second select gate electrode SG, the capacitor electrodes 17a, ..., the capacitor sidewall electrodes 19a, ..., and the like illustrated in FIG. 1 are each made of a semiconductor material such as polysilicon, but the present invention is not limited thereto. The memory gate electrode, the first select gate electrode, the second select gate electrode, the capacitor electrodes, and the capacitor sidewall electrodes may be each made of a metallic material such as aluminum (Al), titanium aluminide (TiAl), tantalum carbide (TaC), or tantalum silicon nitride (TaSiN).

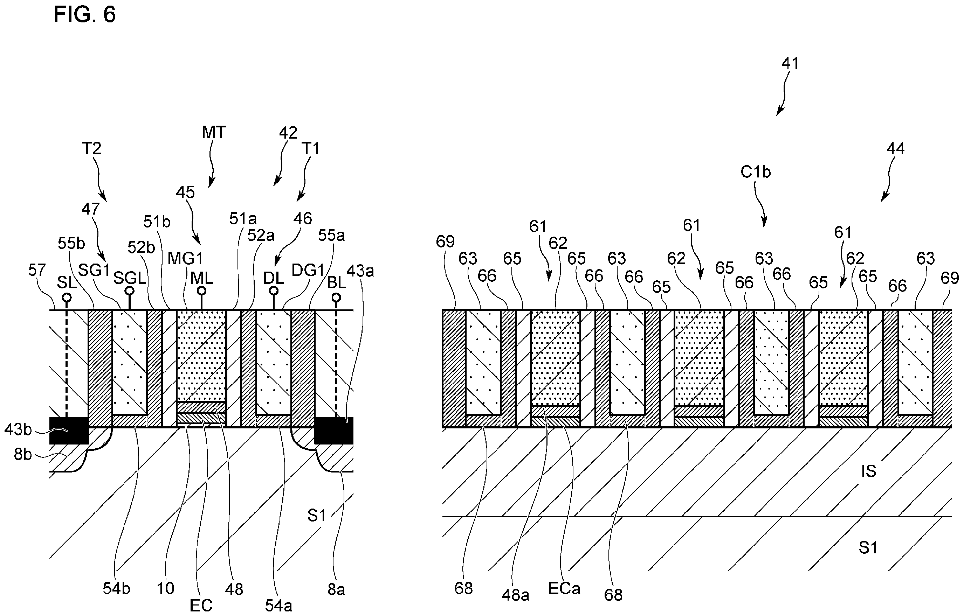

FIG. 6, in which any corresponding part to that in FIG. 1 is denoted by an identical reference sign, illustrates a non-volatile semiconductor memory device 41 in which a memory gate electrode MG1, a first select gate electrode DG1, a second select gate electrode SG1, a capacitor electrode 62, and a capacitor sidewall electrode 63 are each made of a metallic material. The following description will not be made on any configuration same as that of the non-volatile semiconductor memory device 1 illustrated in FIG. 1, but will be made mainly on any difference from the non-volatile semiconductor memory device 1.

A memory cell 42 illustrated in FIG. 6 executes operation in accordance with "(1-1-1) Operation of selected program memory cell", "(1-1-2) Operation of nonselected program memory cell", "(1-1-3) Operation of read memory cell", and "(1-1-4) Operation of erase memory cell" described above, but description thereof will be omitted below to avoid duplicate description.

In this case, the memory cell 42 and a charge pump circuit 44 of the non-volatile semiconductor memory device 41 have upper surfaces planarized by planarization processing such as CMP in a manufacturing process, and are covered by an interlayer insulating layer 57 and another interlayer insulating layer (not illustrated) thereabove.

The memory cell 42 is provided with, for example, on the semiconductor substrate S1, a memory gate structure 45 included in the memory transistor MT, a first select gate structure 46 included in the first select transistor T1, and a second select gate structure 47 included in the second select transistor T2. Silicide layers 43a and 43b are provided on the surfaces of the drain region 8a and the source region 8b, respectively. A wall-shaped sidewall part 55a made of, for example, SiN and disposed along a sidewall of the first select gate structure 46 is provided on the surface of the drain region 8a. A wall-shaped sidewall part 55b made of, for example, SiN and disposed along a sidewall of the second select gate structure 47 is provided on the surface of the source region 8b.

In this case, an upper memory gate insulating film 48 of the memory gate structure 45, a first select gate insulating film 54a of the first select gate structure 46, and a second select gate insulating film 54b of the second select gate structure 47 are made of an insulating material (for example, a high-k material such as hafnium oxide (HfO₂), or nitrided hafnium silicate (HfSiON)) different from that of the lower memory gate insulating film 10.

The memory gate structure 45 includes a sidewall spacer 51a made of an insulating material and wall-shaped along a first sidewall thereof, and a gate sidewall insulating film 52a wall-shaped along the sidewall spacer 51a. The memory gate structure 45 is adjacent to the first select gate structure 46 through the sidewall spacer 51a and the gate sidewall insulating film 52a. The memory gate structure 45 also includes a sidewall spacer 51b made of an insulating material and wall-shaped along a second sidewall thereof facing to the first sidewall, and a gate sidewall insulating film 52b wall-shaped along the sidewall spacer 51b. The memory gate structure 45 is adjacent to the second select gate structure 47 through the sidewall spacer 51b and the gate sidewall insulating film 52b. The gate sidewall insulating films 52a and 52b include no charge storage layer EC inside, and are made of an insulating material (for example, a high-k material) different from that of the sidewall spacers 51a and 51b.

The total thickness of the sidewall spacer 51a (51b) and the gate sidewall insulating film 52a (52b) are preferably 5 nm to 40 nm inclusive to avoid any occurrence of breakdown voltage failure to the sidewall spacer 51a (51b) and the gate sidewall insulating film 52a (52b) and decrease of readout current between the memory gate structure 45 and the first select gate structure 46 (the second select gate structure 47).

In the present embodiment, the memory gate electrode MG1, the first select gate electrode DG1, and the second select gate electrode SG1 each made of a metallic material are formed by a damascene method using a sacrificial electrode. The sidewall spacers 51a and 51b are each formed along, for example, sidewalls of a sacrificial electrode provided at a formation planned position of the memory gate electrode MG1, and subsequently, the gate sidewall insulating films 52a and 52b and the like are formed thereon. Then, sacrificial electrodes are formed at formation planned positions of the first select gate electrode DG1 and the second select gate electrode SG1, and then, the interlayer insulating layer 57 is formed and an upper surface thereof is planarized. Thereafter, the sacrificial electrode is removed, and the memory gate electrode MG1, the first select gate electrode DG1, and the second select gate electrode SG1 each made of a metallic material are formed in a space from which the sacrificial electrode has been removed.

The semiconductor substrate S1, on which the above-described memory cell 2 is formed, is provided with the Dixon charge pump circuit 44 including a plurality of capacitive elements C1b and a plurality of PN junction diodes (not illustrated). Although the charge pump circuit 44 includes the plurality of capacitive elements C1b and the plurality of PN junction diodes, FIG. 6 illustrates only one capacitive element C1b.

In the charge pump circuit 44 thus configured, the plurality of capacitive elements C1b are disposed on the insulating layer IS, and the plurality of PN junction diodes (not illustrated) are disposed, for example, at certain positions on the semiconductor substrate S1. Each PN junction diode may be a typical PN junction diode including, for example, N-type and P-type diffusion layers disposed on the surface of the semiconductor substrate S1.

In FIG. 6, which illustrates a sectional configuration at a certain position, the capacitive element C1b has a configuration in which the capacitor sidewall electrode 63 and a capacitor electrode structure 61 are sequentially and alternately arranged with a capacitive sidewall insulating film 65 and an inter-capacitor-electrode insulating film 66 interposed therebetween. A plurality of the capacitor electrode structures 61 having identical configurations are disposed at predetermined intervals on the insulating layer IS and each sandwiched between the capacitor sidewall electrodes 63.

In the present embodiment, each capacitor electrode 62 made of a metallic material and included in the corresponding capacitor electrode structure 61, and each capacitor sidewall electrode 63 made of a metallic material are made of a layer same as that of the memory gate electrode MG1, the first select gate electrode DG1, and the second select gate electrode SG1, and formed by the damascene method using a sacrificial electrode. Specifically, the sacrificial electrode is formed at a formation planned position of the capacitor electrode 62 and a formation planned position of the capacitor sidewall electrode 63 to form the interlayer insulating layer 57, and then, an upper surface thereof is planarized. Thereafter, the sacrificial electrode is removed, and the capacitor electrode 62 and the capacitor sidewall electrode 63 each made of a metallic material are formed in a space from which the sacrificial electrode has been removed.

The capacitor electrode structure 61 has a configuration in which the charge storage layer ECa and an insulating film 48a are stacked on the insulating layer IS, and in addition, the capacitor electrode 62 is disposed on the insulating film 48a. The charge storage layer ECa included in the capacitor electrode structure 61 is formed through a manufacturing process of forming the charge storage layer EC of the memory cell 42 and thus made of a layer same as that of the charge storage layer EC. The insulating film 48a included in the capacitor electrode structure 61 is formed through a manufacturing process of forming the upper memory gate insulating film 48 of the memory cell 42 and thus made of a layer same as that of the upper memory gate insulating film 48.

The wall-shaped capacitive sidewall insulating film 65 is disposed on each of facing sidewalls of the capacitor electrode structure 61, and the wall-shaped inter-capacitor-electrode insulating film 66 made of an insulating material different from that of the capacitive sidewall insulating film 65 is disposed along the capacitive sidewall insulating film 65. The capacitive sidewall insulating film 65 is formed through a manufacturing process of forming the sidewall spacers 51a and 51b of the memory cell 42 and thus made of a layer same as that of the sidewall spacers 51a and 51b. The inter-capacitor-electrode insulating film 66 is formed through a manufacturing process of forming the gate sidewall insulating films 52a and 52b of the memory cell 42 and thus made of a layer same as that of the gate sidewall insulating films 52a and 52b. Accordingly, the capacitive sidewall insulating film 65 is made of an insulating material such as oxide silicon (SiO or SiO₂), and the inter-capacitor-electrode insulating film 66 is made of an insulating material such as a high-k material other than oxide silicon like the gate sidewall insulating films 52a and 52b.

Similarly to the sidewall spacers 51a and 51b and the gate sidewall insulating films 52a and 52b of the memory cell 42, the capacitive sidewall insulating film 65 and the inter-capacitor-electrode insulating film 66 include no charge storage layer ECa inside and is made only of an insulating material. The total thickness of the capacitive sidewall insulating film 65 and the inter-capacitor-electrode insulating film 66 is preferably 5 nm to 40 nm inclusive in accordance with the thicknesses of the sidewall spacer 51a (51b) and the gate sidewall insulating film 52a (52b).

In the present embodiment, when the sidewall spacers 51a and 51b of the memory cell 42 are formed by CVD, the capacitive sidewall insulating film 65 is formed along each sidewall of a sacrificial electrode provided at a formation planned position of the capacitor electrode structure 61 and thus made of a layer same as that of the sidewall spacers 51a and 51b. Accordingly, the capacitive sidewall insulating film 65 has an excellent film quality and high breakdown voltage as compared to those of an oxide film formed by thermally oxidizing polysilicon, and can be highly freely designed to have a thickness without restriction due to consumption of polysilicon through the thermal oxidation.

The capacitive sidewall insulating film 65 is formed as a layer independent and different from those of the lower memory gate insulating film 10, the charge storage layer EC, the upper memory gate insulating film 48, the first select gate insulating film 54a, and the second select gate insulating film 54b, the thicknesses and film qualities of which are restricted to optimize programming operation, reading operation, and erasing operation of the memory cell 42. Thus, the thicknesses and film qualities of the capacitive sidewall insulating film 65 are free from the restriction and thus can be set mainly for breakdown voltage between the capacitor electrode structure 61 and the capacitor sidewall electrode 63.

The capacitor sidewall electrode 63 disposed on the insulating layer IS through an insulating film 68 is provided on a side of a sidewall of each inter-capacitor-electrode insulating film 66, along which the capacitive sidewall insulating film 65 is not disposed. In this case, the capacitor sidewall electrode 63 and the insulating film 68 are also disposed at each end of the capacitive element C1b, and a sidewall part 69 made of, for example, SiN is disposed along sidewalls of the capacitor sidewall electrode 63 and the insulating film 68 at the end.

The non-volatile semiconductor memory device 41 having such a configuration can be formed through a typical semiconductor manufacturing process using a photolithography technique, a deposition technology such as oxidation or CVD, an etching technology, and an ion implantation method, and thus description thereof will be omitted in the following.

Similarly to the non-volatile semiconductor memory device 1 illustrated in FIG. 1, in the non-volatile semiconductor memory device 41 having the above-described configuration illustrated in FIG. 6, the capacitive sidewall insulating films 65 of the charge pump circuit 44 are made of a layer same as that of the sidewall spacers 51a and 51b of the memory cell 42. The configuration leads to an improved breakdown voltage characteristic and a stabilized capacitor characteristic of the capacitive element C1b as compared to conventional configurations. The charge pump circuit 44 does not need a conventionally needed power supply for achieving low voltage application, thereby achieving a simplified and downsized configuration accordingly. In addition to the capacitive sidewall insulating films 65, the inter-capacitor-electrode insulating films 66 are provided in the capacitive element C1b, which leads to further improvement of the breakdown voltage characteristic of the capacitive element C1b.

In the above-described embodiment, the memory gate electrode MG1, the first select gate electrode DG1, the second select gate electrode SG1, the capacitor electrode 62, and the capacitor sidewall electrode 63 are made of a metallic material of one kind, as a memory gate electrode, a first select gate electrode, a second select gate electrode, a capacitor electrode, and a capacitor sidewall electrode, respectively, each containing a metallic material, but the present invention is not limited thereto. For example, a laminated structure of a memory gate electrode, a first select gate electrode, a second select gate electrode, a capacitor electrode, and a capacitor sidewall electrode may be formed by sequentially stacking a plurality of kinds of metallic layers made of metallic materials of different kinds.

### (5) Non-volatile semiconductor memory device including fin

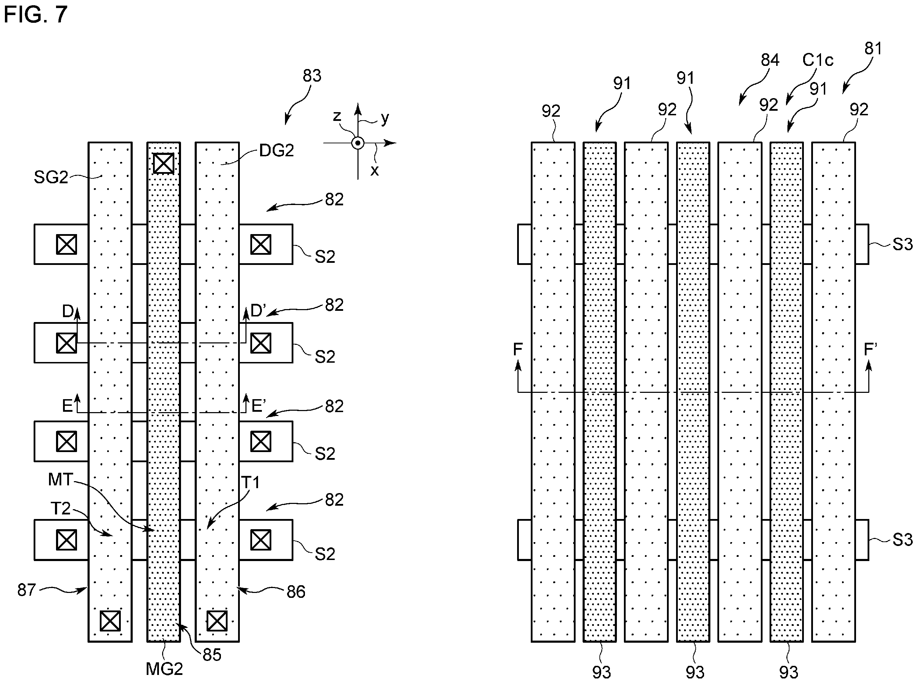

FIG. 7 is a schematic view illustrating a planar layout of a non-volatile semiconductor memory device 81 according to another embodiment in which fins S2 and S3 are provided on a semiconductor substrate. Effects same as those of the above-described embodiment can be obtained with the non-volatile semiconductor memory device 81 including the fins S2 and S3. FIG. 7 mainly illustrates the fins S2 and S3, a memory gate structure 85, a first select gate structure 86, a second select gate structure 87, a capacitor electrode structure 91, and a capacitor sidewall electrode 92. The following description will not be made on any configuration same as those of the non-volatile semiconductor memory device 1 illustrated in FIG. 1 and the non-volatile semiconductor memory device 41 illustrated in FIG. 6, but will be made mainly on any difference from the non-volatile semiconductor memory devices 1 and 41.

A memory cell 82 illustrated in FIG. 7 executes operation in accordance with "(1-1-1) Operation of selected program memory cell", "(1-1-2) Operation of nonselected program memory cell", "(1-1-3) Operation of read memory cell", and "(1-1-4) Operation of erase memory cell" described above, but description thereof will be omitted below to avoid any duplicate description.

In this case, a plurality of fins S2 extend side by side in an x direction in a memory formation part 83 of the non-volatile semiconductor memory device 81, and the memory cell 82 is formed at each fin S2. In the non-volatile semiconductor memory device 81, the memory gate structure 85, the first select gate structure 86, and the second select gate structure 87 extend side by side over the fins S2 in a y direction intersecting with the x direction in which the fins S2 extend.

A fin S3 extends in the x direction in a region in which a charge pump circuit 84 is disposed. The capacitor electrode structure 91 and the capacitor sidewall electrode 92 extend side by side over the fin part S3 in the y direction intersecting with the x direction.

The distance between the fins S3 extending side by side and the number thereof are set to the fins S3 provided in the region in which the charge pump circuit 84 is disposed so that the capacitance of a capacitive element C1c formed on a surface of each fin S3 (capacitance between the capacitor electrode structure 91 and the capacitor sidewall electrode 92) is not affected by the capacitance between the fin S3 and the capacitor electrode structure 91 and the capacitance between the fin S3 and the capacitor sidewall electrode 92. In the example, the fins S3 are provided in the region in which the charge pump circuit 84 is disposed, but the present invention is not limited thereto. No fin may be provided in the region in which the charge pump circuit 84 is disposed, but the fins S2 may be provided only in the memory formation part 83.

In the present embodiment, a memory gate electrode MG2 of the memory gate structure 85, a first select gate electrode DG2 of the first select gate structure 86, a second select gate electrode SG2 of the second select gate structure 87, a capacitor electrode 93 of the capacitor electrode structure 91, and the capacitor sidewall electrode 92 are each made of a metallic material such as aluminum (Al), titanium aluminide (TiAl), tantalum carbide (TaC), or tantalum silicon nitride (TaSiN).

In the memory formation part 83, the memory gate structure 85 is disposed between the first select gate structure 86 and the second select gate structure 87.

The memory cell 82 including the memory transistor MT, the first select transistor T1, and the second select transistor T2 is disposed in a region in which the memory gate structure 85, the first select gate structure 86, and the second select gate structure 87 extend over the fins S2.

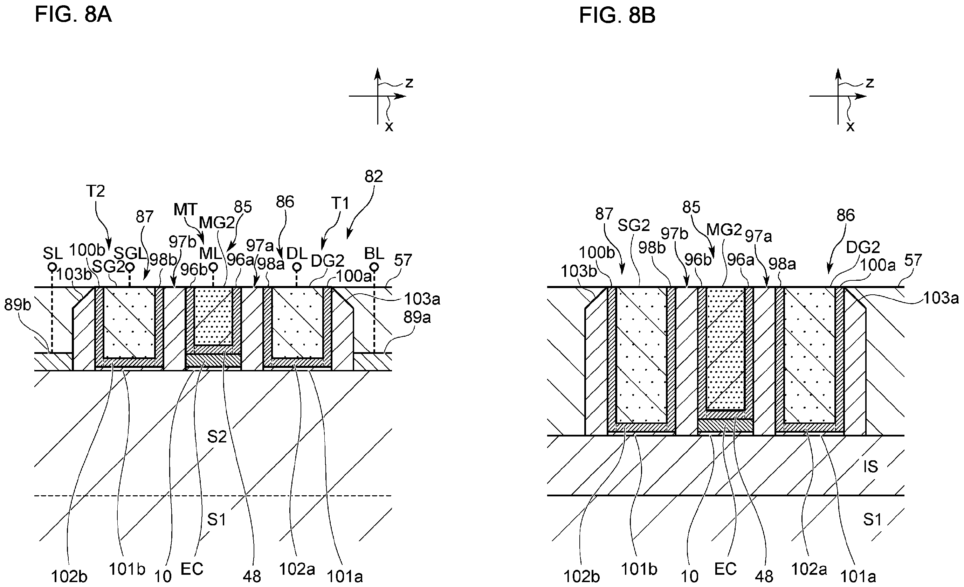

As illustrated in FIG. 8A of a sectional configuration taken along line D-D' in FIG. 7, the first select gate structure 86, the memory gate structure 85, and the second select gate structure 87 are provided between a drain region 89a and a source region 89b disposed on a surface of each fin S2 in the memory cell 82. The drain region 89a and the source region 89b, which are disposed on the surface of the fin S2 at an interval, are each made of a semiconductor material such as SiGe and selectively formed on the surface of the fin S2 by epitaxial growth to have predetermined thicknesses.

In the memory gate structure 85, the upper memory gate insulating film 48, which is made of an insulating material (for example, a high-k material such as hafnium oxide (HfO₂), or nitrided hafnium silicate (HfSiON)) different from that of the lower memory gate insulating film 10, is disposed on the fin S2 through the lower memory gate insulating film 10 and the charge storage layer EC, and the memory gate electrode MG2 is provided on the upper memory gate insulating film 48.

A wall-shaped sidewall spacer 97a made of an insulating material is disposed along a first sidewall of the memory gate structure 85. A wall-shaped first gate sidewall insulating film 96a is provided between the sidewall spacer 97a and the memory gate electrode MG2. In addition, a wall-shaped sidewall spacer 97b made of an insulating material is disposed along a second sidewall of the memory gate structure 85. A wall-shaped first gate sidewall insulating film 96b is provided between the sidewall spacer 97b and the memory gate electrode MG2. The first gate sidewall insulating films 96a and 96b are formed through a manufacturing process same as that of the upper memory gate insulating film 48, and thus made of an insulating material (for example, a high-k material) same as that of the upper memory gate insulating film 48 and integrated with the upper memory gate insulating film 48.

In the first select gate structure 86, a lower first select gate insulating film 101a made of an insulating material such as oxide silicon (SiO or SiO₂) is provided between the sidewall spacer 97a and a sidewall part 103a on the fins S2, and an upper first select gate insulating film 102a made of an insulating material (for example, a high-k material) different from that of the first select gate insulating film 101a is provided on the lower first select gate insulating film 101a.

In the first select gate structure 86, a wall-shaped second gate sidewall insulating film 98a is disposed along the sidewall spacer 97a, and a wall-shaped sidewall-part sidewall insulating film 100a is disposed along a sidewall of the sidewall part 103a. The second gate sidewall insulating film 98a and the sidewall-part sidewall insulating film 100a are formed through a manufacturing process of forming the upper first select gate insulating film 102a and thus made of an insulating material (for example, a high-k material) different from those of the lower first select gate insulating film 101a and the sidewall spacer 97a. The total thickness of the lower first select gate insulating film 101a and the upper first select gate insulating film 102a is preferably less than or equal to 9 nm, more preferably, less than or equal to 3 nm.

In the first select gate structure 86, the first select gate electrode DG2 made of a metallic material same as that of the memory gate electrode MG2 is disposed on the upper first select gate insulating film 102a, and the second gate sidewall insulating film 98a and the sidewall-part sidewall insulating film 100a are disposed along a sidewall of the first select gate electrode DG2.

In the second select gate structure 87, a lower second select gate insulating film 101b made of an insulating material such as oxide silicon (SiO or SiO₂) is provided on each fin S2 between the sidewall spacer 97b and a sidewall part 103b, and an upper second select gate insulating film 102b made of an insulating material (for example, a high-k material) different from that of the second select gate insulating film 101b is provided on the lower second select gate insulating film 101b.

In the second select gate structure 87, a wall-shaped second gate sidewall insulating film 98b is disposed along the sidewall spacer 97b, and a wall-shaped sidewall-part sidewall insulating film 100b is disposed along a sidewall of the sidewall part 103b. The second gate sidewall insulating film 98b and the sidewall-part sidewall insulating film 100b are formed through a manufacturing process of forming the upper second select gate insulating film 102b and thus made of an insulating material (for example, a high-k material) different from those of the lower second select gate insulating film 101b and the sidewall spacer 97b. The total thickness of the lower second select gate insulating film 101b and the upper second select gate insulating film 102b is preferably less than or equal to 9 nm, more preferably less than or equal to 3 nm.

In the second select gate structure 87, the second select gate electrode SG2 made of a metallic material same as that of the memory gate electrode MG2 is disposed on the upper second select gate insulating film 102b, and the second gate sidewall insulating film 98b and the sidewall-part sidewall insulating film 100b are disposed along sidewalls of the second select gate electrode SG2.

Similarly to the above-described embodiment, in the present embodiment, the total thickness of the first gate sidewall insulating film 96a (96b), the sidewall spacer 97a (97b), and the second gate sidewall insulating film 98a (98b) is preferably 5 nm to 40 nm inclusive.

The following description will be made with reference to FIG. 8B illustrating a sectional configuration taken along line E-E' in FIG. 7. As illustrated in FIG. 8B, in a region in which no fin S2 is disposed, the memory gate structure 85, the first select gate structure 86, the second select gate structure 87, the sidewall spacers 97a and 97b, and the sidewall parts 103a and 103b illustrated in FIG. 8A are disposed on the insulating layer IS covering the semiconductor substrate S1.

The surface of the insulating layer IS is positioned lower than an upper surface of each fin S2 in the region in which no fin S2 is disposed. Accordingly, the first select gate structure 86, the memory gate structure 85, the second select gate structure 87, the sidewall spacers 97a and 97b, and the sidewall parts 103a and 103b are more vertically elongated than a region in which the fin S2 is disposed, and thus have heights same as those in the region in which the fin S2 is disposed.

In addition to the above-described configuration, in the non-volatile semiconductor memory device 81 according to the present invention, the insulating layer IS is provided on the semiconductor substrate S1 on which the memory cell 82 is disposed. The charge pump circuit 84 including the capacitive element C1c as illustrated in FIG. 7 is provided on the insulating layer IS.

As in the above-described embodiment, the charge pump circuit 84 is a Dixon charge pump circuit including a plurality of capacitive elements C1c each having a configuration same as that of the above-described capacitive element C1c, and a plurality of PN junction diodes. The charge pump circuit 84 is configured to generate the high output voltage V2 increased according to the operation principle of a Dixon charge pump circuit. The following description will be made mainly on the configuration of one of the capacitive elements C1c as illustrated in FIG. 7 to avoid any duplicate description.

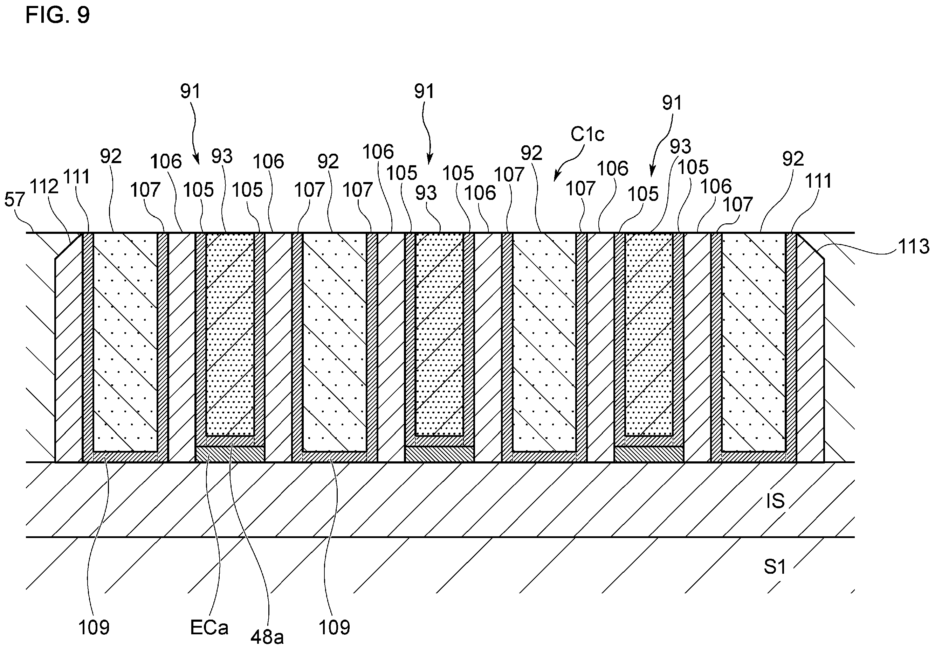

FIG. 9 is a schematic view illustrating a sectional configuration taken along line F-F' in FIG. 7. As illustrated in FIG. 9, in the capacitive element C1c, a capacitive sidewall insulating film 106 is provided between each pair of the capacitor sidewall electrode 92 and the capacitor electrode structure 91. The height of a region in which the capacitive element C1c is disposed is same as that of a region in which the fins S2 and S3 are disposed. Accordingly, in the region in which the capacitive element C1c is disposed where the insulating layer IS has an upper surface positioned lower than the upper surfaces of the fins S2 and S3, the capacitor electrode structure 91, the capacitor sidewall electrode 92, the capacitive sidewall insulating film 106, and the like are more vertically elongated than in the region in which the fins S2 and S3 are disposed. Accordingly, the capacitor sidewall electrodes 92 face to the capacitor electrode structures 91 in larger areas, which leads to increase of the capacitance of the capacitive element C1c.

The capacitive sidewall insulating film 106 is formed through a manufacturing process of forming the sidewall spacers 97a and 97b of the memory cell 82, and thus made of a layer same as that of the sidewall spacers 97a and 97b. In the present embodiment, each capacitive sidewall insulating film 106 is formed along a sidewall of a sacrificial electrode provided at a formation planned position of each capacitor electrode structure 91 when the sidewall spacers 97a and 97b of the memory cell 82 are formed by CVD, and thus is made of a layer same as that of the sidewall spacers 97a and 97b. Accordingly, the capacitive sidewall insulating film 106 has an excellent film quality and high breakdown voltage as compared to those of an oxide film formed by thermally oxidizing polysilicon, and can be highly freely designed to have a thickness without restriction due to consumption of polysilicon through the thermal oxidation.

The capacitive sidewall insulating film 106 is formed as a layer independent and different from those of the lower memory gate insulating film 10, the charge storage layer EC, the upper memory gate insulating film 48, the first select gate insulating film 101a, and the second select gate insulating film 101b, the thicknesses and film qualities of which are restricted to optimize programming operation, reading operation, and erasing operation of the memory cell 82. Thus, the thicknesses and film qualities of the capacitive sidewall insulating film 106 are free from this restriction, and thus can be set mainly for breakdown voltage between the capacitor electrode structure 91 and the capacitor sidewall electrode 92.

In the capacitor electrode structure 91, the charge storage layer ECa and the insulating film 48a are stacked on the insulating layer IS, and the capacitor electrode 93 is disposed on the insulating film 48a. The charge storage layer ECa of the capacitor electrode structure 91 is formed through a manufacturing process of forming the charge storage layer EC of the memory cell 82 and thus made of a layer same as that of the charge storage layer EC. The insulating film 48a of the capacitor electrode structure 91 is formed through a manufacturing process of forming the upper memory gate insulating film 48 of the memory cell 82 and thus made of a layer same as that of the upper memory gate insulating film 48.

In the capacitor electrode structure 91, a wall-shaped first inter-capacitor-electrode insulating film 105 is disposed between each capacitive sidewall insulating film 106 and the capacitor electrode 93. The first inter-capacitor-electrode insulating film 105 is formed through a manufacturing process of forming the insulating film 48a of the capacitor electrode structure 91, the first gate sidewall insulating films 96a and 96b and the second gate sidewall insulating films 98a and 98b of the memory cell 82, and the like, and thus made of a layer same as that of the insulating film 48a, the first gate sidewall insulating films 96a and 96b, and the like.

A wall-shaped second inter-capacitor-electrode insulating film 107 made of an insulating material different from that of the capacitive sidewall insulating film 106 is disposed on a sidewall of each capacitive sidewall insulating film 106, on which the first inter-capacitor-electrode insulating film 105 is not disposed. Similarly to the first inter-capacitor-electrode insulating film 105 disposed on the sidewall of the capacitor electrode 93, the second inter-capacitor-electrode insulating film 107 is formed through a manufacturing process of forming the first gate sidewall insulating films 96a and 96b and the second gate sidewall insulating films 98a and 98b of the memory cell 82, and thus made of a layer same as that of the first gate sidewall insulating films 96a and 96b and the second gate sidewall insulating films 98a and 98b of the memory cell 82.

The capacitor sidewall electrode 92 disposed on an insulating film 109 is provided on a side of a sidewall of each second inter-capacitor-electrode insulating film 107, on which the capacitive sidewall insulating film 106 is not disposed. A wall-shaped sidewall insulating film 111 made of an insulating material (for example, SiN) same as that of the inter-capacitor-electrode insulating film 107 is disposed along sidewalls of the insulating film 109 and the capacitor sidewall electrode 92 at an end of the capacitive element C1c. In addition, a sidewall part 112 or 113 made of an insulating material (for example, SiO or SiO₂) same as that of the capacitive sidewall insulating film 106 is provided along a sidewall of the sidewall insulating film 111.

The non-volatile semiconductor memory device 81 having such a configuration can be formed through a typical semiconductor manufacturing process using a photolithography technique, a deposition technology such as oxidation or CVD, an etching technology, and an ion implantation method, and thus description thereof will be omitted in the following.

Similarly to the non-volatile semiconductor memory device 1 illustrated in FIG. 1, in the non-volatile semiconductor memory device 81 having the above-described configuration, each capacitive sidewall insulating film 106 of the charge pump circuit 84 is made of a layer same as that of the sidewall spacers 97a and 97b of the memory cell 82. The configuration leads to an improved breakdown voltage characteristic and a stabilized capacitor characteristic of the capacitive element C1c as compared to conventional configurations. The charge pump circuit 84 does not need a conventionally needed power supply for achieving low voltage application, thereby achieving a simplified and downsized configuration accordingly.

In the capacitive element C1c, the first inter-capacitor-electrode insulating film 105 and the second inter-capacitor-electrode insulating film 107, which are made of a layer same as that of the first gate sidewall insulating films 96a and 96b and the second gate sidewall insulating films 98a and 98b disposed along the sidewall spacers 97a and 97b of the memory cell 82, are provided between each pair of the capacitor electrode 93 and the capacitor sidewall electrode 92. The first inter-capacitor-electrode insulating film 105 and the second inter-capacitor-electrode insulating film 107 further improve the breakdown voltage characteristic of the capacitive element C1c.

### (6) Others

The present invention is not limited to the above-described embodiments, but various kinds of modifications are possible without departing from the scope of the present invention, which is defined by the appended claims. For example, each operation may be executed through application of any voltage value other than voltage values in "(1-1-1) Operation of selected program memory cell", "(1-1-2) Operation of nonselected program memory cell", "(1-1-3) Operation of read memory cell", and "(1-1-4) Operation of erase memory cell".

In the above-described non-volatile semiconductor memory device 1 illustrated FIG. 1, only the sidewall spacers 13a and 13b are provided in the memory cell 2, and only the capacitive sidewall insulating film 21 is provided on the capacitive elements C1 and C2 of the charge pump circuit 4; in an example not forming part of the claimed invention, another gate sidewall insulating film made of an insulating material different from that of the sidewall spacers 13a and 13b may be provided along each of the sidewall spacers 13a and 13b of the memory cell 2. A wall-shaped inter-capacitor-electrode insulating film made of a layer same as that of the gate sidewall insulating film may be provided, together with the capacitive sidewall insulating film 21, between the capacitor electrodes 17a and 17b and the capacitor sidewall electrodes 19a and 19b in the capacitive elements C1 and C2 of the charge pump circuit 4. In another configuration of the capacitive elements C1 and C2, the first inter-capacitor-electrode insulating film 105 as illustrated in FIG. 9 may be provided along each sidewall of the capacitor electrodes 17a and 17b.

In the capacitive element C1b illustrated in FIG. 6, the inter-capacitor-electrode insulating films 66 are provided in addition to the capacitive sidewall insulating films 65, but the present invention is not limited thereto; in an example not forming part of the claimed invention, only the capacitive sidewall insulating films 65 may be provided. In another configuration of the capacitive element C1b, the first inter-capacitor-electrode insulating film 105 as illustrated in FIG. 9 may be provided along each sidewall of the capacitor electrodes 62.

In the above-described capacitive element C1c illustrated in FIG. 9, the first inter-capacitor-electrode insulating films 105 and the second inter-capacitor-electrode insulating films 107 are provided in addition to the capacitive sidewall insulating films 106; in an example not forming part of the claimed invention, only the capacitive sidewall insulating films 106 may be provided. Alternatively, in an example not forming part of the claimed invention, only the first inter-capacitor-electrode insulating films 105 or the second inter-capacitor-electrode insulating films 107 may be provided.

The configurations according to the above-described embodiments illustrated in FIGS. 1, 3, and 5 to 9 may be combined in various manners to achieve a configuration in which a capacitive sidewall insulating film made of a layer same as that of a sidewall spacer of a memory cell is provided between a capacitor sidewall electrode and a capacitor electrode in each capacitive element of a charge pump circuit.

In the above-described embodiment, the voltage of the first clock φ1 or the second clock φ2 is applied to a capacitor electrode; in an example not forming part of the claimed invention, the voltage of the first clock φ1 or the second clock φ2 may be applied to a capacitor sidewall electrode.

### Reference Signs List

1, 41, 81 non-volatile semiconductor memory device
2, 42, 82 memory cell
4, 31, 44, 84 charge pump circuit
5, 45, 85 memory gate structure
6, 46, 86 first select gate structure
7, 47, 87 second select gate structure
10 lower memory gate insulating film
11, 48 upper memory gate insulating film
13a, 13b, 51a, 51b, 97a, 97b sidewall spacer
17a, 17b, 62, 93 capacitor electrode
21, 32, 65, 106 capacitive sidewall insulating film
28 conduction part
19a, 19b, 36a, 36b, 36c, 36d, 63, 92 capacitor sidewall electrode
52a, 52b, 96a, 96b, 98a, 98b gate sidewall insulating film
66, 105, 107 inter-capacitor-electrode insulating film
MG, MG1, MG2 memory gate electrode
DG, DG1, DG2 first select gate electrode
SG, SG1, SG2 second select gate electrode
EC charge storage layer
C1, C2, C1a, C2a, C3a, C4a, C1b, C1c capacitive element
D1, D2, D3, D1a, D2a, D3a, D4a, D5a PN junction diode

## Claims

1. A non-volatile semiconductor memory device (1) comprising:
a memory cell (2, 42) provided on a semiconductor substrate (S1); and
a charge pump circuit (4) disposed on an insulating layer (IS) provided on the semiconductor substrate (S1),
wherein the memory cell (2, 42) includes:
a memory gate structure (5) in which a lower memory gate insulating film (10), a charge storage layer (EC), an upper memory gate insulating film (11), and a memory gate electrode (MG) are stacked;
a first sidewall spacer (13a, 51a) made of an insulating material and provided along one side surface of the memory gate structure (5);
a second sidewall spacer (13b, 51b) made of the insulating material and provided along another side surface of the memory gate structure (5);
a first select gate structure (6) that is disposed along the first sidewall spacer (13a, 51a) and in which a first select gate electrode (DG) is provided on a first select gate insulating film (12a);
a second select gate structure (7) that is disposed along the second sidewall spacer (13b, 51b) and in which a second select gate electrode (SG) is provided on a second select gate insulating film (12b);
a drain region (8a) provided adjacent to the first select gate structure (6) on a surface of the semiconductor substrate (S1), insulated from the first select gate electrode (DG), and electrically connected with a bit line (BL); and
a source region (8b) provided adjacent to the second select gate structure (7) on the surface of the semiconductor substrate (S1), insulated from the second select gate electrode (SG), and electrically connected with a source line (SL),
the charge pump circuit (4) includes a plurality of capacitive elements (C1, C2) defining a number of stages ,
each capacitive element (C1, C2) includes, between a capacitor electrode (17a, 17b) and a capacitor sidewall electrode (19a, 19b), a capacitive sidewall insulating film (21) made of a layer of the same material and same thickness as a layer of the first sidewall spacer (13a) and the second sidewall spacer (13b),
the charge pump circuit (4) includes
one of the capacitive elements (C1) at an odd-numbered stage, being configured such that on its respective capacitor electrode (17a) a voltage of a first clock (ϕ1) is applied; another one of the capacitive elements (C2) at
an even-numbered stage, being configured such that on its respective another capacitor electrode (17b) a voltage of a second clock (ϕ2) having a phase opposite to a phase of the first clock (ϕ1) is applied; and
a PN junction diode (D2) electrically connected-between the capacitive element (C1) and the other capacitive element (C2); and
the PN junction diode (D2) includes
an opposite-conductivity-type junction part (15b) made of a layer of the same material and same thickness as a layer of the capacitor sidewall electrode (19a, 19b) and having a conductivity type different from a conductivity type of the capacitor sidewall electrode (19a, 19b); and
a conduction part (28) electrically connecting the opposite-conductivity-type junction part (15b) and the capacitor sidewall electrode (19a) provided on the capacitive element (C1) at the odd-numbered stage.

2. The non-volatile semiconductor memory device (1) according to claim 1, wherein
the capacitor electrode (17a, 17b) is made of a layer of the same material and same thickness as a layer of the memory gate electrode (MG), and
the capacitor sidewall electrode (19a, 19b) is made of a layer of the same material and same thickness as a layer of the first select gate electrode (DG) and the second select gate electrode (SG).

3. The non-volatile semiconductor memory device (1) according to claim 1 or 2, wherein
the capacitive element (C1, C2) includes a capacitor electrode structure (16a) in which a charge storage layer (ECa), an insulating film (11a), and the capacitor electrode (17a, 17b) are stacked, and
the capacitive sidewall insulating film (21) is made of an insulating material being the same material and having the same thickness as an insulating material of the first sidewall spacer (13a) and the second sidewall spacer (13b), disposed along a sidewall of the capacitor electrode structure (16a), and not including the charge storage layer (ECa) provided in the capacitor electrode structure (16a) .

4. The non-volatile semiconductor memory device (1) according claim 1 or 2, wherein the capacitive sidewall insulating film (21) has a same thickness as thicknesses of the first sidewall spacer (13a) and the second sidewall spacer (13b).

5. The non-volatile semiconductor memory device (1) according to any one of claims 1 to 4, wherein the memory gate electrode (MG), the first select gate electrode (DG), the second select gate electrode (SG), the capacitor electrode (17a, 17b), and the capacitor sidewall electrode (19a, 19b) each contain a metallic material.

6. The non-volatile semiconductor memory device (41) according to any one of claims 1 to 5, wherein
the memory cell (42) includes a gate sidewall insulating film (52a, 52b) wall-shaped along the sidewall spacer (51a, 51b), and
an inter-capacitor-electrode insulating film (66) made of a layer of the same material and same thickness as a layer of the gate sidewall insulating film (52a, 52b) is provided between the capacitor electrode (62) and the capacitor sidewall electrode (63) of the capacitive element (C1b).

## Patentansprüche

1. Nichtflüchtige Halbleiterspeichervorrichtung (1), aufweisend:
eine Speicherzelle (2, 42), die auf einem Halbleitersubstrat (S1) vorgesehen ist; und
eine Ladepumpenschaltung (4), die auf einer Isolierschicht (IS) angeordnet ist, die auf dem Halbleitersubstrat (S1) vorgesehen ist,
wobei die Speicherzelle (2, 42) umfasst:
eine Speichergatestruktur (5), in welcher ein unterer Speichergate-Isolierfilm (10), eine Ladungsspeicherschicht (EC), ein oberer Speichergate-Isolierfilm (11) und eine Speichergateelektrode (MG) gestapelt sind;
einen ersten Seitenwandabstandshalter (13a, 51a), der aus einem Isoliermaterial hergestellt und entlang einer Seitenfläche der Speichergatestruktur (5) vorgesehen ist;
einen zweiten Seitenwandabstandshalter (13b, 51b), der aus einem Isoliermaterial hergestellt und entlang einer anderen Seitenfläche der Speichergatestruktur (5) vorgesehen ist;
eine erste Selektionsgatestruktur (6), die entlang des ersten Seitenwandabstandshalters (13a, 51a) angeordnet ist und in der eine erste Selektionsgateelektrode (DG) auf einem ersten Selektionsgate-Isolierfilm (12a) vorgesehen ist;
eine zweite Selektionsgatestruktur (7), die entlang des zweiten Seitenwandabstandshalters (13b, 51b) angeordnet ist und in der eine zweite Selektionsgateelektrode (SG) auf einem zweiten Selektionsgate-Isolierfilm (12b) vorgesehen ist;
eine Drainregion (8a), die benachbart zur ersten Selektionsgatestruktur (6) auf einer Oberfläche des Halbleitersubstrats (S1) vorgesehen, von der ersten Selektionsgateelektrode (DG) isoliert und mit einer Bitleitung (BL) elektrisch verbunden ist; und
eine Sourceregion (8b), die benachbart zur zweiten Selektionsgatestruktur (7) auf der Oberfläche des Halbleitersubstrats (S1) vorgesehen, von der zweiten Selektionsgateelektrode (SG) isoliert und mit einer Sourceleitung (SL) elektrisch verbunden ist,
wobei die Ladepumpenschaltung (4) eine Mehrzahl von kapazitiven Elementen (C1, C2) umfasst, die eine Anzahl von Stufen definiert, wobei jedes kapazitive Element (C1, C2) zwischen einer Kondensatorelektrode (17a, 17b) und einer Kondensator-Seitenwandelektrode (19a, 19b) einen kapazitiven Seitenwandisolierfilm (21) umfasst, der aus einer Schicht des gleichen Materials und der gleichen Dicke wie eine Schicht des ersten Seitenwandabstandshalters (13a) und des zweiten Seitenwandabstandshalters (13b) hergestellt ist,
die Ladepumpenschaltung (4) umfasst:
eines der kapazitiven Elemente (C1) auf einer ungeradzahligen Stufe, das derart ausgelegt ist, dass an seine jeweilige Kondensatorelektrode (17a) eine Spannung eines ersten Takts (ϕ1) angelegt wird;
ein anderes der kapazitiven Elemente (C2) auf einer geradzahligen Stufe, das so ausgelegt ist, dass an seine jeweilige andere Kondensatorelektrode (17b) eine Spannung eines zweiten Takts (ϕ2) mit einer Phase anlegt, die zu einer Phase des ersten Takts (ϕ1) entgegengesetzt ist; und
eine PN-Übergangsdiode (D2), die elektrisch zwischen das kapazitive Element (C1) und das andere kapazitive Element (C2) geschaltet ist; und
wobei die PN-Übergangsdiode (D2) umfasst:
einen Übergangsteil eines entgegengesetzten Leitfähigkeitstyps (15b), der aus einer Schicht des gleichen Materials und der gleichen Dicke wie eine Schicht der Kondensator-Seitenwandelektrode (19a, 19b) hergestellt ist und einen Leitfähigkeitstyp aufweist, der von einem Leitfähigkeitstyp der Kondensator-Seitenwandelektrode (19a, 19b) verschieden ist; und
und einen Leitungsteil (28), der den Übergangsteil des entgegengesetzten Leitfähigkeitstyps (15b) und die auf dem kapazitiven Element (C1) auf der ungeradzahligen Stufe vorgesehene Kondensator-Seitenwandelektrode (19a) elektrisch verbindet.

2. Nichtflüchtige Halbleiterspeichervorrichtung (1) nach Anspruch 1, wobei
die Kondensatorelektrode (17a, 17b) aus einer Schicht des gleichen Materials und der gleichen Dicke wie eine Schicht der Speichergateelektrode (MG) hergestellt ist, und
die Kondensator-Seitenwandelektrode (19a, 19b) aus einer Schicht des gleichen Materials und der gleichen Dicke wie eine Schicht der ersten Selektionsgateelektrode (DG) und der zweiten Selektionsgateelektrode (SG) hergestellt ist.

3. Nichtflüchtige Halbleiterspeichervorrichtung (1) nach Anspruch 1 oder 2, wobei
das kapazitive Element (C1, C2) eine Kondensatorelektrodenstruktur (16a) umfasst, in welcher eine Ladungsspeicherschicht (ECa), ein Isolierfilm (11a) und die Kondensatorelektrode (17a, 17b) gestapelt sind, und
der kapazitive Seitenwandisolierfilm (21) aus einem Isoliermaterial hergestellt ist, das das gleiche Material wie ein Isoliermaterial des ersten Seitenwandabstandshalters (13a) und des zweiten Seitenwandabstandshalters (13b) ist und die gleiche Dicke wie diese aufweist, entlang einer Seitenwand der Kondensatorelektrodenstruktur (16a) angeordnet ist, und nicht die Ladungsspeicherschicht (ECa) umfasst, die in der Kondensatorelektrodenstruktur (16a) vorgesehen ist.

4. Nichtflüchtige Halbleiterspeichervorrichtung (1) nach Anspruch 1 oder 2, wobei der kapazitive Seitenwandisolierfilm (21) eine gleiche Dicke wie Dicken des ersten Seitenwandabstandshalters (13a) und des zweiten Seitenwandabstandshalters (13b) aufweist.

5. Nichtflüchtige Halbleiterspeichervorrichtung (1) nach einem der Ansprüche 1 bis 4, wobei die Speichergateelektrode (MG), die erste Selektionsgateelektrode (DG), die zweite Selektionsgateelektrode (SG), die Kondensatorelektrode (17a, 17b), und die Kondensator-Seitenwandelektrode (19a, 19b) jeweils ein metallisches Material enthalten.

6. Nichtflüchtige Halbleiterspeichervorrichtung (41) nach einem der Ansprüche 1 bis 5, wobei
die Speicherzelle (42) einen Gate-Seitenwandisolierfilm (52a, 52b) wandförmig entlang des Seitenwandabstandshalters (51a, 51b) umfasst, und
ein Inter-Kondensator-Elektroden-Isolierfilm (66), der aus einer Schicht des gleichen Materials und der gleichen Dicke wie eine Schicht des Gate-Seitenwandisolierfilms (52, 52b) hergestellt ist, zwischen der Kondensatorelektrode (62) und der Kondensator-Seitenwandelektrode (63) des kapazitiven Elements (C1b) vorgesehen ist.

## Revendications

1. Mémoire à semi-conducteur non volatile (1) comprenant :
une cellule de mémoire (2, 42) prévue sur un substrat semi-conducteur (S1) ; et
un circuit de pompe de charge (4) disposé sur une couche isolante (IS) prévue sur le substrat semi-conducteur (S1),
dans laquelle la cellule de mémoire (2, 42) inclut :
une structure de grille de mémoire (5) dans laquelle un film isolant de grille de mémoire inférieur (10), une couche de stockage de charge (EC), un film isolant de grille de mémoire supérieur (11) et une électrode de grille de mémoire (MG) sont empilés ;
un premier espaceur de paroi latérale (13a, 51a) composé d'un matériau isolant et prévu le long d'une surface latérale de la structure de grille de mémoire (5) ;
un second espaceur de paroi latérale (13b, 51b) composé du matériau isolant et prévu le long d'une autre surface latérale de la structure de grille de mémoire (5) ;
une première structure de grille de sélection (6) qui est disposée le long du premier espaceur de paroi latérale (13a, 51a) et dans laquelle une première électrode de grille de sélection (DG) est prévue sur un premier film isolant de grille de sélection (12a) ;
une seconde structure de grille de sélection (7) qui est disposée le long du second espaceur de paroi latérale (13b, 51b) et dans laquelle une seconde électrode de grille de sélection (SG) est prévue sur un second film isolant de grille de sélection (12b) ;
une région de drain (8a) prévue de manière adjacente à la première structure de grille de sélection (6) sur une surface du substrat semi-conducteur (S1), isolée de la première électrode de grille de sélection (DG), et connectée électriquement avec une ligne de bits (BL) ; et
une région de source (8b) prévue de manière adjacente à la seconde structure de grille de sélection (7) sur la surface du substrat semi-conducteur (S1), isolée de la seconde électrode de grille de sélection (SG), et connectée électriquement à une ligne source (SL),
le circuit de pompe de charge (4) inclut une pluralité d'éléments capacitifs (C1, C2) définissant un nombre d'étages,
chaque élément capacitif (C1, C2) inclut, entre une électrode de condensateur (17a, 17b) et une électrode de paroi latérale de condensateur (19a, 19b), un film isolant de paroi latérale capacitif (21) composé d'une couche du même matériau et de même épaisseur qu'une couche du premier espaceur de paroi latérale (13a) et du second espaceur de paroi latérale (13b),
le circuit de pompe de charge (4) inclut un des éléments capacitifs (C1) au niveau d'un étage de nombre impair, étant conçu de telle sorte que sur son électrode de condensateur (17a) respective, une tension d'une première horloge (cp1) est appliquée ;
un autre des éléments capacitifs (C2) au niveau d'un étage de nombre pair, étant conçu de telle sorte que sur son autre électrode de condensateur (17b) respective une tension d'une seconde horloge (ϕ2) ayant une phase opposée à une phase de la première horloge (cp1) est appliquée ; et
une diode à jonction PN (D2) connectée électriquement entre l'élément capacitif (C1) et l'autre élément capacitif (C2) ; et
la diode à jonction PN (D2) inclut
une partie de jonction de type à conductivité opposée (15b) composée d'une couche du même matériau et de même épaisseur qu'une couche de l'électrode de paroi latérale de condensateur (19a, 19b) et ayant un type de conductivité différent d'un type de conductivité de l'électrode de paroi latérale de condensateur (19a, 19b) ; et
une partie de conduction (28) connectant électriquement la partie de jonction de type à conductivité opposée (15b) et l'électrode de paroi latérale de condensateur (19a) prévue sur l'élément capacitif (C1) au niveau de l'étage de nombre impair.

2. Mémoire à semi-conducteur non volatile (1) selon la revendication 1, dans laquelle
l'électrode de condensateur (17a, 17b) est composée d'une couche du même matériau et de même épaisseur qu'une couche de l'électrode de grille de mémoire (MG), et
l'électrode de paroi latérale de condensateur (19a, 19b) est composée d'une couche du même matériau et de même épaisseur qu'une couche de la première électrode de grille de sélection (DG) et de la seconde électrode de grille de sélection (SG).

3. Mémoire à semi-conducteur non volatile (1) selon la revendication 1 ou 2, dans laquelle
l'élément capacitif (C1, C2) inclut une structure d'électrode de condensateur (16a) dans laquelle une couche de stockage de charge (ECa), un film isolant (11a), et l'électrode de condensateur (17a, 17b) sont empilés, et
le film isolant de paroi latérale capacitif (21) est composé d'un matériau isolant étant le même matériau et ayant la même épaisseur qu'un matériau isolant du premier espaceur de paroi latérale (13a) et du second espaceur de paroi latérale (13b), disposé le long d'une paroi latérale de la structure d'électrode de condensateur (16a), et n'incluant pas la couche de stockage de charge (ECa) prévue dans la structure d'électrode de condensateur (16a).

4. Mémoire à semi-conducteur non volatile (1) selon la revendication 1 ou 2, dans laquelle le film isolant de paroi latérale capacitif (21) a une même épaisseur que les épaisseurs du premier espaceur de premier paroi latérale (13a) et du second espaceur de paroi latérale (13b).

5. Mémoire à semi-conducteur non volatile (1) selon l'une quelconque des revendications 1 à 4, dans laquelle l'électrode de grille de mémoire (MG), la première électrode de grille de sélection (DG), la seconde électrode de grille de sélection (SG), l'électrode de condensateur (17a, 17b) et l'électrode de paroi latérale de condensateur (19a, 19b) contiennent chacune un matériau métallique.

6. Mémoire à semi-conducteur non volatile (1) selon l'une quelconque des revendications 1 à 5, dans laquelle
la cellule de mémoire (42) inclut un film isolant de paroi latérale de grille (52a, 52b) en forme de paroi le long de l'espaceur de paroi latérale (51a, 51b) ; et
un film isolant entre le condensateur et l'électrode (66) composé d'une couche du même matériau et de même épaisseur qu'une couche du film isolant de paroi latérale de grille (52a, 52b) est prévu entre l'électrode de condensateur (62) et l'électrode de paroi latérale de condensateur (63) de l'élément capacitif (C1b).
